# EUROPEAN PATENT SPECIFICATION

(11) **EP 2 520 618 B1**
(45) Date of publication and mention of the grant of the patent: **02.09.2015**
(21) Application number: 10841135.6
(22) Date of filing: 01.12.2010
(51) Int. Cl.: C08K 5/00, C08L 25/18, C08L 65/00, C08L 101/12, C09K 11/06, H01B 1/12, H01L 51/00, H05B 33/12

(54) **CONDUCTIVE POLYMER, CONDUCTIVE POLYMER COMPOSITION, CONDUCTIVE POLYMER COMPOSITION FILM, AND PHOTOELECTRIC DEVICE USING SAME**
LEITFÄHIGES POLYMER, LEITFÄHIGE POLYMERZUSAMMENSETZUNG, LEITFÄHIGE POLYMERZUSAMMENSETZUNGSFOLIE UND PHOTOELEKTRISCHE VORRICHTUNG DAMIT
POLYMÈRE CONDUCTEUR, COMPOSITION DE POLYMÈRE CONDUCTEUR, FILM DE COMPOSITION DE POLYMÈRE CONDUCTEUR ET DISPOSITIF PHOTOÉLECTRIQUE L'UTILISANT

(30) Priority: 29.12.2009 KR 20090133230
(43) Date of publication of application: 07.11.2012
(73) Proprietor: Cheil Industries Inc., Kumi-city, Kyungsangbuk-do 730-030 (KR)
(72) Inventor: HUH, Dal-Ho, Uiwang-si Gyeonggi-do 437-711 (KR); LEE, Kyoung-Mi, Uiwang-si Gyeonggi-do 437-711 (KR); KANG, Eui-Su, Uiwang-si Gyeonggi-do 437-711 (KR); CHAE, Mi-Young, Uiwang-si Gyeonggi-do 437-711 (KR); LEE, Jeong-Woo, Uiwang-si Gyeonggi-do 437-711 (KR)
(74) Representative: Michalski Hüttermann & Partner Patentanwälte mbB
(86) International application number: PCT/KR2010/008555
(87) International publication number: WO 2011/081302

(56) References cited:
- EP-A1- 1 634 922
- WO-A1-2010/074432
- KR-A- 20060 120 378
- KR-A- 20070 048 076
- KR-A- 20080 077 876
- US-A1- 2008 105 854

## Description

### CROSS-REFERENCE TO RELATED APPLICATION

This application claims priority to and the benefit of Korean Patent Application No. 10-2009-0133230 filed in the Korean Intellectual Property Office on December 29, 2009. .

### BACKGROUND OF THE INVENTION

### (a) Field of the Invention

A conductive polymer, a conductive polymer composition, a conductive polymer composition layer, and an organic photoelectric device using the same are related. More particularly, the present invention relates to an electrical conductivity polymer being capable improving efficiency and life-span of an organic photoelectric device by including an organic ionic salt, and an organic photoelectric device using the same.

### (b) Description of the Related Art

A photoelectric device is a device for transforming photo-energy to electrical energy and conversely, for transforming electrical energy to photo-energy. The photoelectric device may be exemplified by an organic light emitting diode, a solar cell, a transistor, and the like.

Particularly, among these photoelectric devices, the organic light emitting diodes (OLED) has recently drawn attention due to increasing demand for a flat panel display (FPD).

Recently, LCDs, which have been remarkably developed through technology, have had an increased market share of greater than or equal to 80% in the FPD market but have critical demerits in that the response speed is slow and the viewing angle is narrow in a wide display of 40 inches or larger. In order to overcome the demerits, a new alternative display is needed.

In this regard, the organic light emitting diode has drawn attention as a display mode for the next generation FPD since it has many merits in that it is driven at a low voltage, it is self-light-emitting, it can be formed as a thin film, it has a wide viewing angle, high response speed, and high contrast, and is economical to produce.

In the field of photoelectric devices including the organic light emitting diode, researchers are studying the formation of a conductive polymer layer in order to improve efficiency of a photoelectric device by smoothly transferring charges generated in an electrode, that is, holes and electrons, to the photoelectric device.

Particularly, an organic light emitting diode is an active light emitting display device that takes advantage of a phenomenon in which electrons and holes are combined in an organic layer while emitting light when an electrical current flows to a fluorescent or phosphorescent organic compound thin film (hereinafter referred to as an organic layer). The organic light emitting diode does not use a single light emission layer as the organic layer but employs a multi-layer structure including a hole injection layer (HIL) using a conductive polymer, a light emission layer, and an electron injection layer (EIL) to improve efficiency and decrease the driving voltage.

The multi-layer structure can be simplified by making one layer perform a plurality of functions. One of the simplest OLED structures is a structure where an organic layer performing all functions including the function of a light emission layer is interposed between two electrodes.

However, to substantially increase luminance, an electron injection layer (EIL) or a hole injection layer should be introduced to an electrical light emitting assembly.

The literature discloses many organic compounds that are capable of transferring charges (which are holes and electrons). As examples, European Patent Publication No. 387 715, U.S. Patent No. 4,539,507, U.S. Patent No. 4,720,432, and U.S. Patent No. 4,769,292 disclose organic compounds and their usages.

Particularly, Baytron-P, which is commercially available in the market and produced by the Bayer AG Company, is a representative organic compound that is capable of transferring charges, and it is soluble and is used to produce organic electro-luminescence (EL). Baytron-P is a kind of PEDOT (poly(3,4-ethylene dioxythiophene))-PSS (poly(4-styrene sulfonate)) aqueous solution.

PEDOT-PSS is widely used for fabrication of an organic light emitting diode. It is used to form a hole injection layer (HIL) by spin-coating it on an indium tin oxide (ITO) electrode. The PEDOT-PSS has a structure as shown in the following Chemical Formula 22.

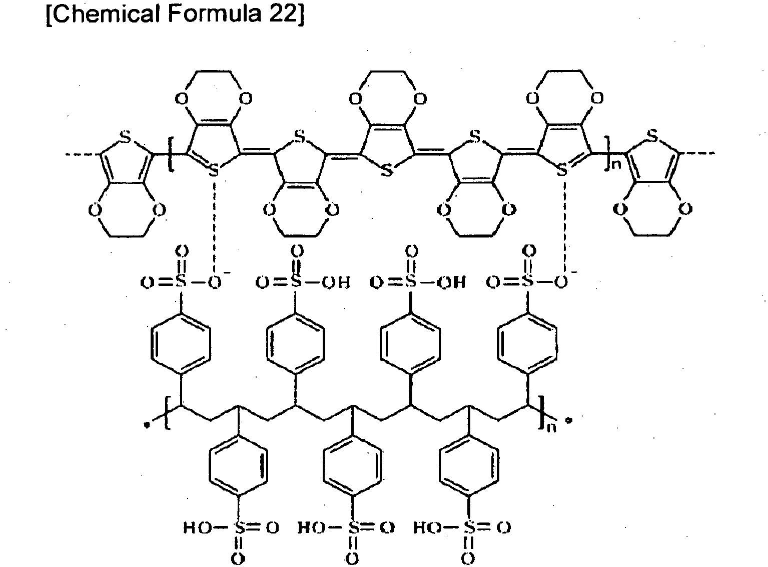

The PEDOT-PSS expressed in the above Chemical Formula 22 is a simple ion composite of a polyacid, which is poly(4-styrene sulfonate) (PSS), and a conductive polymer, which is poly(3,4-ethylenedioxythiophene) (PEDOT). It has a structure in which PEDOT is doped with a water-soluble polyacid.

The PSS is dedoped by degradation, or a part of the PSS may be decomposed through a reaction with electrons to thereby emit a material such as a sulfate. The emitted material may be diffused into a neighboring organic layer, such as a light emission layer. The diffusion of a material originating from the hole injection layer (HIL) into the light emission layer causes exciton quenching to thereby decrease the efficiency and life-span of the organic light emitting diode.

Accordingly, research on improving efficiency and life-span of an organic light emitting diode using an electrical conductivity polymer capable of compensating a drawback has been made.

Conductive polymers are *inter alia* disclosed in the WO 2010/074432 and EP 1 634 922.

### SUMMARY OF THE INVENTION

A conductive polymer including an organic ionic salt being capable of improving efficiency and life-span of an organic photoelectric device is provided as defined in the appended claims.

A conductive polymer composition, a conductive polymer composition layer, and an organic photoelectric device using the conductive polymer are provided as defined in the appended claims.

The embodiments of the present invention are not limited to the above technical purposes, and a person of ordinary skill in the art can understand other technical purposes:

According to one aspect of the present disclosure, a conductive polymer doped with a polyacid copolymer represented by the following Chemical Formula 1 is provided.

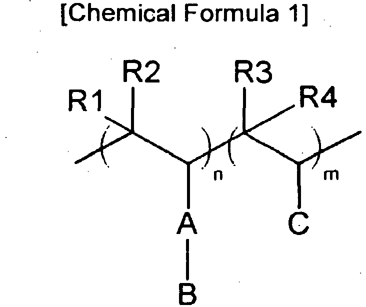

In Chemical Formula 1, A is a carbon-based group, and is selected from the group consisting of a substituted or unsubstituted C1 to C30 alkyl group; a substituted or unsubstituted C1 to C30 heteroalkyl group; a substituted or unsubstituted C1 to C30 alkoxy group; a substituted or unsubstituted C1 to C30 heteroalkoxy group; a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group; a substituted or unsubstituted C2 to C30 heteroaryloxy group; a substituted or unsubstituted C5 to C20 cycloalkyl group; a substituted or unsubstituted C2 to C30 heterocycloalkyl group; a substituted or unsubstituted C1 to C30 alkylester group; a substituted or unsubstituted C1 to C30 heteroalkylester group; a substituted or unsubstituted C6 to C30 arylester group; and a substituted or unsubstituted C2 to C30 heteroarylester group, B is an ionic group or a group including an ionic group, wherein the ionic group include a pair of a cation and an anion, the cation is a metal ion of Na⁺, K⁺, Li⁺, Mg²⁺, Zn²⁺, or Al³⁺, H⁺, NH₃⁺, or an organic ion of CH₃(-CH₂-)ₙ (n is a natural number of 1 to 50 ), and the anion is PO₃⁻, SO₃⁻, COO⁻, I⁻, or CH₃COO⁻, C is a cation of an organic ion salt including an anion and a cation, R1 to R4 are the same or different, and are independently selected from the group consisting of hydrogen, a substituted or unsubstituted C1 to C10 alkyl, a substituted or unsubstituted C6 to C20 aryl, and a substituted or unsubstituted C3 to C20 heteroaryl, 0<m≤10,000,000, 0<n<10,000,000, and 0.0001≤m/n≤100.

According to an exemplary embodiment, C is one of the following Chemical Formulae 2 to 5.

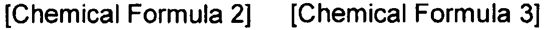

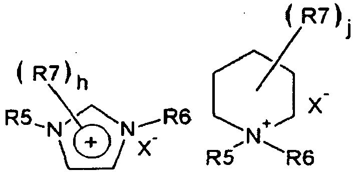

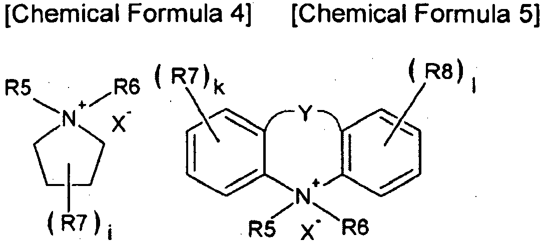

In Chemical Formulae 2 to 5, one of R5 to R8 is selected from the group consisting of a substituted or unsubstituted C1 to C30 alkylene group, a substituted or unsubstituted C1 to C30 heteroalkylene group, a substituted or unsubstituted C1 to C30 alkoxylene group, a substituted or unsubstituted C1 to C30 heteroalkoxylene group, a substituted or unsubstituted C6 to C30 arylene group, a substituted or unsubstituted C6 to C30 arylalkylene group, a substituted or unsubstituted C2 to C30 heteroarylene group, a substituted or unsubstituted C2 to C30 heteroarylalkylene group, a substituted or unsubstituted C5 to C20 cycloalkylene group, and a substituted or unsubstituted C2 to C30 heterocycloalkylene group, and is bound to a main chain at its one end, and the rest one of R5 to R8 is the same or different and is independently selected from the group consisting of hydrogen, a substituted or unsubstituted C1 to C30 alkyl group, a substituted or unsubstituted C1 to C30 heteroalkyl group, a substituted or unsubstituted C1 to C30 alkoxy group, a substituted or unsubstituted C1 to C30 heteroalkoxy group, a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group, a substituted or unsubstituted C2 to C30 heteroaryloxy group, a substituted or unsubstituted C5 to C20 cycloalkyl group, a substituted or unsubstituted C2 to C30 heterocycloalkyl group, a substituted or unsubstituted C1 to C30 alkylester group, a substituted or unsubstituted C1 to C30 heteroalkylester group, a substituted or unsubstituted C6 to C30 arylester group, and a substituted or unsubstituted C2 to C30 heteroarylester group, X of X- is selected from the group consisting of F, Cl, Br, I, BF₄, PF₆ and (CnF₂ₙ₊₁SO₂)₂N (n is a natural number of 1 to 50), Y is selected from the group consisting of -CH₂-, -CR'R"-, -NH-, -NR'-, -O-, -P-, -P=O-, -S-, and -SiR'R"-, wherein R' and R" are the same or different and are independently selected from the group consisting of hydrogen, a substituted or unsubstituted C1 to C10 an alkyl, a substituted or unsubstituted C6 to C20 aryl, and a substituted or unsubstituted C3 to C20 heteroaryl, h is an integer of 1 to 3, i is an integer of 1 to 8, j is an integer of 1 to 10, k is an integer of 1 to 4, and I is an integer of 1 to 4.

According to one exemplary embodiment, the conductive polymer may be a polymer which is obtained by polymerizing one selected from the group consisting of a monomer of polyphenylene, polyphenylenevinylene, polyaniline, or a derivative thereof represented the following Chemical Formula 6; a monomer of pyrrole represented by the following Chemical Formula 7, a monomer of thiophene or a derivative thereof.

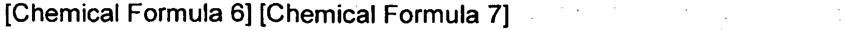

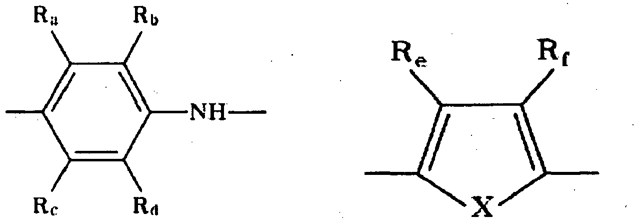

In Chemical Formulae 6 and 7, X is NH; or a heteroatom such as N, O, S, or P bound to a C1 to C20 alkyl group or a C6 to C20 aryl group, and Ra, Rb, Rc, and Rd are the same or different and independently selected from the group consisting of hydrogen; a C1 to C30 alkyl group; a C1 to C30 heteroalkyl group; a C1 to C30 alkoxy group; a C1 to C30 heteroalkoxy group; a C6 to C30 aryl group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group, and Re and Rf are the same or different and independently NH; or a heteroatom such as N, O, S, or P bound to a C1 to C20 alkyl group or a C6 to C20 aryl group; a C1 to C30 alkyl group; a C6 to C30 aryl group; a C1 to C30 alkoxy group; a C1 to C30 heteroalkyl group; a C1 to C30 heteroalkoxy group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group.

According to one exemplary embodiment, the conductive polymer may be a polymer obtained by polymerizing a compound represented by the following Chemical Formula 8 as a monomer.

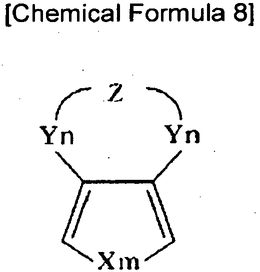

In Chemical Formula 8, X is NH, or a heteroatom such as N, O, S, or P bound to a C1 to C20 alkyl group or a C6 to C20 aryl group, Y is NH, or a heteroatom such as N, O, S, or P bound to a C1 to C20 alkyl group or a C6 to C20 aryl group, m and n are each independently an integer ranging from 0 to 9, Z is -(CH₂)ₓ-CRgRh-(CH₂)_{y}, and Rg and Rh are the same or different and independently selected from H, a C1 to C20 alkyl radical, a C6 to C14 aryl radical, and -CH₂-ORi, wherein Ri is selected from the group consisting of H, a C1 to C6 alkyl acid a C1 to C6 alkylester, a C1 to C6 heteroalkyl acid, and a C1 to C6 alkylsulfonic acid.

According to another aspect of the present invention, a conductive polymer composition for an organic photoelectric device including the above conductive polymer and a solvent is provided.

According to one exemplary embodiment, the solvent may be at least one solvent selected from the group consisting of water, alcohol, dimethyl formamide (DMF), dimethylsulfoxide, toluene, xylene, and chlorobenzene.

According to one exemplary embodiment, the conductive polymer composition may further include a physical cross-linking agent or a chemical cross-linking agent.

According to one exemplary embodiment, the physical cross-linking agent may be at least one selected from the group consisting of glycerol, butanol, polyvinylalcohol, polyethyleneglycol, polyethyleneimine, and polyvinylpyrrolidone.

According to one exemplary embodiment, the chemical cross-linking agent may be at least one selected from the group consisting of tetraethyloxysilane, polyaziridine, a melamine-based polymer, and an epoxy-based polymer.

According to one exemplary embodiment, the physical cross-linking agent may be included in an amount of 0.001 to 5 parts by weight based on 100 parts by weight of the conductive polymer composition according to claim 5.

According to one exemplary embodiment, the chemical cross-linking agent may be included in an amount of 0.001 to 50 parts by weight by weight based on 100 parts by weight of the conductive polymer composition according to claim 5.

According to yet another aspect of the present invention, a conductive polymer composition layer for an organic photoelectric device formed using the conductive polymer composition is provided.

According to still another aspect of the present invention, an organic photoelectric device including the conductive polymer composition layer is provided.

An organic photoelectric device having excellent luminous efficiency and life-span may be realized.

### BRIEF DESCRIPTION OF THE DRAWINGS

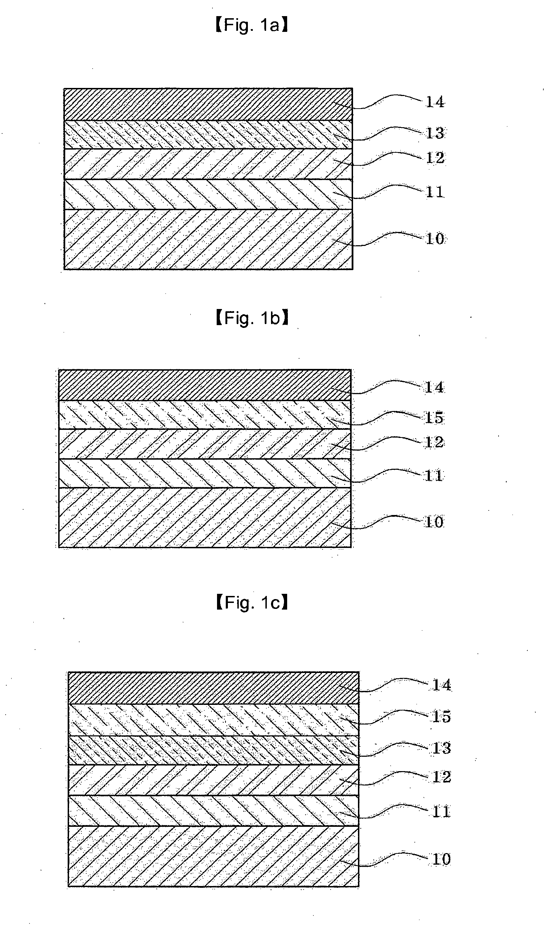

FIGS. 1A to 1D are schematic cross-sectional views showing organic light emitting diodes according to embodiments of the present invention.

### <Description of Reference Numerals Indicating Primary Elements in the Drawings>

| | | | |
|---|---|---|---|
| 10: | first electrode | 11: | buffer layer |
| 12: | emission layer | 13: | hole blocking layer |
| 14: | second electrode | 15: | electron transport layer |
| 16: | hole transport layer (HTL) | | |

### DETAILED DESCRIPTION

Exemplary embodiments of the present invention will hereinafter be described in detail. However, these embodiments are only exemplary, and the present invention is not limited thereto.

The conductive polymer of the present disclosure is a conductive polymer doped with a polyacid copolymer represented by the following Chemical Formula 1.

In order to solve technical objects, the conductive polymer composition of the present invention includes a conductive polymer dispersed in a solvent, and further includes a physical cross-linking agent and/or a chemical cross-linking agent added there to.

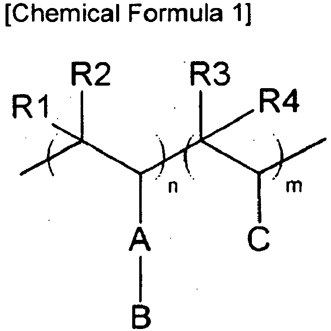

In Chemical Formula 1, A is a carbon-based group, and is selected from the group consisting of a substituted or unsubstituted C1 to C30 alkyl group; a substituted or unsubstituted C1 to C30 heteroalkyl group; a substituted or unsubstituted C1 to C30 alkoxy group; a substituted or unsubstituted C1 to C30 heteroalkoxy group; a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group; a substituted or unsubstituted C2 to C30 heteroaryloxy group; a substituted or unsubstituted C5 to C20 cycloalkyl group; a substituted or unsubstituted C2 to C30 heterocycloalkyl group; a substituted or unsubstituted C1 to C30 alkylester group; a substituted or unsubstituted C1 to C30 heteroalkylester group; a substituted or unsubstituted C6 to C30 arylester group; and a substituted or unsubstituted C2 to C30 heteroarylester group, B is an ionic group or a group including an ionic group, wherein the ionic group include a pair of a cation and an anion, the cation is a metal ion of Na⁺, K⁺, Li⁺, Mg²⁺, Zn²⁺, or Al³⁺, H⁺, NH₃⁺, or an organic ion of CH₃(-CH₂-)ₙ (n is a natural number of 1 to 50), and the anion is PO3⁻, SO3⁻, COO⁻, I⁻, or CH₃COO⁻, C is a cation of an organic ion salt including an anion and a cation, R1 to R4 are the same or different, and are independently selected from the group consisting of hydrogen, a substituted or unsubstituted C1 to C10 alkyl, a substituted or unsubstituted C6 to C20 aryl, and a substituted or unsubstituted C3 to C20 heteroaryl, 0<m≤10,000,000, 0<n<10,000,000, and 0.0001 ≤m/n≤100.

The polyacid copolymer represented by the above Chemical Formula 1 is ion-bounded to and doped to the conductive polymer.

C is one of the following Chemical Formulae 2 to 5.

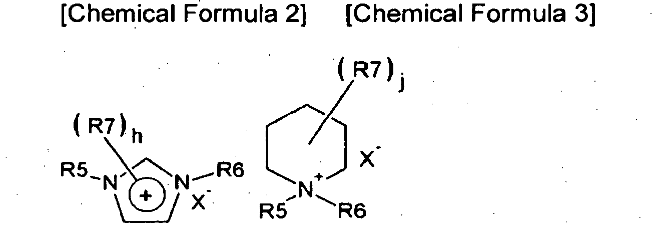

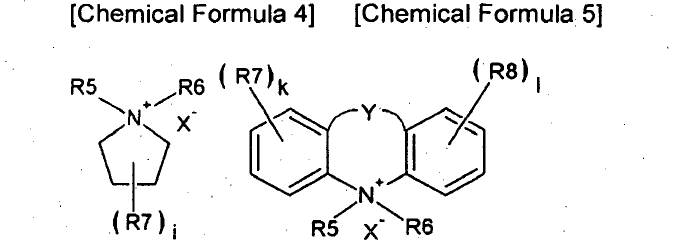

In Chemical Formulae 2 to 5, one of R5 to R8 is selected from the group consisting of a substituted or unsubstituted C1 to C30 alkylene group, a substituted or unsubstituted C1 to C30 heteroalkylene group, a substituted or unsubstituted C1 to C30 alkoxylene group, a substituted or unsubstituted C1 to C30 heteroalkoxylene group, a substituted or unsubstituted C6 to C30 arylene group, a substituted or unsubstituted C6 to C30 arylalkylene group, a substituted or unsubstituted C2 to C30 heteroarylene group, a substituted or unsubstituted C2 to C30 heteroarylalkylene group, a substituted or unsubstituted C5 to C20 cycloalkylene group, and a substituted or unsubstituted C2 to C30 heterocycloalkylene group, and is bound to a main chain at its one end, and the rest one of R5 to R8 is the same or different and is independently selected from the group consisting of hydrogen, a substituted or unsubstituted C1 to C30 alkyl group, a substituted or unsubstituted C1 to C30 heteroalkyl group, a substituted or unsubstituted C1 to C30 alkoxy group, a substituted or unsubstituted C1 to C30 heteroalkoxy group, a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group, a substituted or unsubstituted C2 to C30 heteroaryloxy group, a substituted or unsubstituted C5 to C20 cycloalkyl group, a substituted or unsubstituted C2 to C30 heterocycloalkyl group, a substituted or unsubstituted C1 to C30 alkylester group, a substituted or unsubstituted C1 to C30 heteroalkylester group, a substituted or unsubstituted C6 to C30 arylester group, and a substituted or unsubstituted C2 to C30 heteroarylester group, X of X- is selected from the group consisting of F, Cl, Br, I, BF₄, PF₆, and (CnF₂ₙ₊₁SO₂)₂N (n is a natural number of 1 to 50), Y is selected from the group consisting of -CH₂-, -CR'R"-, -NH-, -NR'-, -O-, -P-, -P=O-, -S-, and -SiR'R"-, wherein R' and R" are the same or different and are independently selected from the group consisting of hydrogen, a substituted or unsubstituted C1 to C10 an alkyl, a substituted or unsubstituted C6 to C20 aryl, and a substituted or unsubstituted C3 to C20 heteroaryl, h is an integer of 1 to 3, i is an integer of 1 to 8, j is an integer of 1 to 10, k is an integer of 1 to 4, and I is an integer of 1 to 4.

When the h, i, j, and k is an integer of greater than or equal to 2, R7 and/or R8 substituent is plural. Herein, a plurality of R7 and/or R8 substituents are the same or different and independent from each other.

According to the embodiment of the present invention, since the organic ionic salt substituent included in a conductive polymer may prevent phase separation of a conductive polymer composition that will be described hereinafter, the composition may need no separate solvent.

The organic ionic salt substituent has a dipole moment and thus, high polarity and also, good solubility in a polar solvent including water and thus, may be well mixed with a conductive polymer composition. Accordingly, an organic photoelectric device using the organic ionic salt substituent may have a long life-span.

In addition, since the conductive polymer composition including the conductive polymer having the organic ionic salt substituent is well dissolved in a polar organic solvent or moisture, the conductive polymer composition may not only prevent damage on an organic layer neighboring therewith, that is, an emission layer formed using a non-polar solvent when applied to a photoelectric device but also use other polar organic solvents.

The conductive polymer may be generally-used conductive polymers used in an organic photoelectric device, for example a polymer which is obtained by polymerizing one selected from the group consisting of a monomer of polyphenylene, polyphenylenevinylene, polyaniline, or a derivative thereof represented the following Chemical Formula 6; a monomer of pyrrole represented by the following Chemical Formula 7, a monomer of thiophene or a derivative thereof.

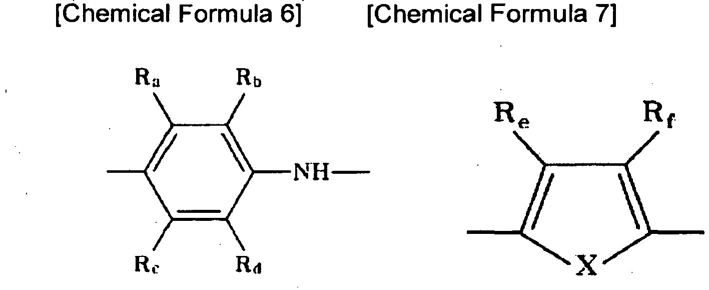

In Chemical Formulae 6 and 7, X is NH; or a heteroatom such as N, O, S, or P bound to a C1 to C20 alkyl group or a C6 to C20 aryl group, and Ra, Rb, Rc, and Rd are the same or different and independently hydrogen; a C1 to C30 alkyl group; a C1 to C30 heteroalkyl group; a C1 to C30 alkoxy group; a C1 to C30 heteroalkoxy group; a C6 to C30 aryl group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group, Re and Rf are the same or different and independently NH; or a heteroatom such as N, O, S, or P bound to a C1 to C20 alkyl group, or a C6 to C20 aryl group; a C1 to C30 alkyl group; a C6 to C30 aryl group; a C1 to C30 alkoxy group; a C1 to C30 heteroalkyl group; a C1 to C30 heteroalkoxy group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group.

The conductive polymer may be a polymer obtained by polymerizing a compound represented by the following Chemical Formula 8 as a monomer.

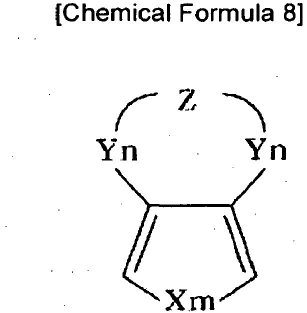

In Chemical Formula 8, X is NH, or a heteroatom such as N, O, S, or P bound to a C1 to C20 alkyl group or a C6 to C20 aryl group, Y is NH, or a heteroatom such as N, O, S, or P bound to a C1 to C20 alkyl group or a C6 to C20 aryl group, m and n are each independently an integer ranging from 0 to 9, Z is -(CH₂)ₓ-CRgRh-(CH₂)_{y}, and Rg and Rh are the same or different and independently selected from H, a C1 to C20 alkyl radical, a C6 to C14 aryl radical, and -CH₂-ORi, wherein Ri is selected from the group consisting of H, a C1 to C6 alkyl acid a C1 to C6 alkylester, a C1 to C6 heteroalkyl acid, and a C1 to C6 alkylsulfonic acid.

According to one embodiment of the present invention, the conductive polymer may include a small amount of residual groups decomposed due to reaction with electrons and a functional group bringing about a morphology change and thus, prevent distribution by the electron, accomplishing high efficiency and long life-span of a photoelectric device.

As used herein, as a substituent, an alkyl group may be a linear or branched and may be methyl, ethyl, propyl, isobutyl, sec-butyl, tert-butyl, pentyl, iso-amyl, hexyl, and the like, wherein at least one hydrogen of the alkyl group may be substituted with a hydroxy group, a nitro group, a cyano group, an amino group (-NH₂, -NH(R), -N(R')(R"), wherein R, R' and R" are independently a C1 to C10 alkyl group), an amidino group, a hydrazine, or hydrazone group.

As a substitutent of the present invention, a heteroalkyl group may be an alkyl group where one or more carbon atoms of its main chain, preferably 1 to 5 carbon atoms are substituted with hetero atom such as an oxygen atom (O), a sulfur atom (S), a nitrogen atom (N), a phosphorus atom (P), and the like.

As a substitutent of the present invention, an aryl group refers to carbocycle aromatic molecules including at least one of aromatic cycles, and the cycles may be bound as a pendent group or fused.

Examples of the aryl group may be an aromatic group such as phenyl, naphthyl, tetrahydronaphthyl, and the like, and at least one hydrogen atom of the aryl group may be substituted as in the alkyl group.

As a substitutent of the present invention, a heteroaryl group refers to a 5-membered to 30-membered cyclic aromatic group including one to three hetero atoms selected from N, O, P, or S, and remaining carbon atoms, wherein cyclics are attached as a pendant or are fused to each other.

At least one hydrogen atom of the heteroaryl group may be substituted as in the alkyl group.

As a substitutent of the present invention, an alkoxy group may include methoxy, ethoxy, propoxy, isobutyloxy, sec-butyloxy, pentyloxy, iso-amyloxy, hexyloxy, and the like, and at least one hydrogen atom of the alkoxy group may be substituted as in the alkyl group.

As a substitutent of the present invention, an arylalkyl group may be an aryl group where a part of hydrogen atoms may be substituted with a lower alkyl, for example a radical such as methyl, ethyl, propyl, and the like. Examples of the arylalkyl group may be benzylmethyl, phenylethyl, and the like.

At least one hydrogen atom of the arylalkyl group may be substituted as in the alkyl group.

As a substitutent of the present invention, a heteroarylalkyl group may be a heteroaryl group where a part of hydrogen atoms may be substituted with a lower alkyl. Heteroaryl of the heteroarylalkyl group is defined as described above. At least one hydrogen atom of the heteroarylalkyl group may be substituted as in the alkyl group.

As a substitutent of the present invention, an aryloxy group may be an aryl radical bound to an oxygen atom, wherein aryl is the same as described above. Examples of aryloxy group may include phenoxy, naphthoxy, anthracenyloxy, phenanthrenyloxy, fluorenyloxy, indenyloxy, and the like, and at least one hydrogen atom of the aryloxy group may be may be substituted as in the alkyl group.

As a substitutent of the present invention, a heteroaryloxy group refers to a heteroaryl radical bound to an oxygen atom, wherein the heteroaryl is the same as defined above.

As a substitutent of the present invention, at least one hydrogen atom of the heteroaryloxy group may be substituted as in the alkyl group.

As a substitutent of the present invention, a cycloalkyl group may refer to a C5 to C30 monovalent monocyclic system.

At least one hydrogen atom of the cycloalkyl group may be substituted as in the alkyl group.

As a substitutent of the present invention, a heterocycloalkyl group refers a 5-membered to 30-membered monocyclic group including one to three hetero atoms selected from N, O, P, or S.

At least one hydrogen atom of the cycloalkyl group may be substituted as in the alkyl group.

As a substitutent of the present invention, an amino group may be -NH₂, -NH(R) or -N(R')(R"), wherein R, R', and R" are each independently a C1 to C10 alkyl group.

As a substitutent of the present invention, a halogen refers to fluorine, chlorine, bromine, iodine, or astatine, and fluorine particularly preferable.

The conductive polymer according to one exemplary embodiment of the present disclosure includes the polyacid copolymer represented by the above Chemical Formula 1 doped to the above described conductive polymer by an ionic bond.

In addition, the conductive polymer is dispersed into a solvent to prepare a composition, which may form a layer.

The composition is defined as a conductive polymer composition, and the conductive polymer composition may further include all of the components such as an organic ionic salt, a physical cross-linking agent, and a chemical cross-linking agent other than a solvent or optionally the components.

The solvent included in the conductive polymer composition according to one embodiment of the present invention may include any solvent capable of dissolving the conductive polymer but at least one solvent selected from the group consisting of water, alcohols, dimethyl formamide (DMF), dimethylsulfoxide, toluene, xylene, and chlorobenzene.

In addition, a conductive polymer composition according to the present invention may further include a cross-linking agent to improve cross-linking capability of a conductive polymer. Herein, the cross-linking agent may be a physical and/or chemical cross-linking agent.

The physical cross-linking agent used in the present invention may play a role of cross-linking polymer chains and is a low molecular or polymer compound including a hydroxy group (-OH).

Examples of the physical cross-linking agent may include a low molecular compound such as glycerol, butanol, and the like, a polymer compound such as polyvinyl alcohol, polyethyleneglycol, and the like and also, polyethyleneimine, polyvinylpyrrolidone, and the like.

The physical cross-linking agent may be included in an amount of 0.001 to 5 parts by weight based on 100 parts by weight of the conductive polymer and in another embodiment, 0.1 to 3 parts by weight.

When the physical cross-linking agent is included within the range, it may have efficient performance and effectively maintain thin film morphology of a conductive polymer layer.

The chemical cross-linking agent plays a role of cross-linking polymer chains and may bring about in-situ polymerization and form an interpenetrating polymer network (IPN).

The chemical cross-linking agent may mainly use a silane-based material, for example, tetraethyloxysilane (TEOS).

Polyaziridine, melamine-based, epoxy-based material may also be used.

The chemical cross-linking agent may be included in an amount of 0.001 to 50 parts by weight based on 100 parts by weight of the conductive polymer including an organic ionic salt and 1 to 10 parts by weight in another embodiment.

When the chemical cross-linking agent is included within the range, it may have effective performance but have no large influence on a conductive polymer, sufficiently maintaining conductivity.

When the conductive polymer composition is formed into a conductive polymer layer, a solvent included in the composition should be mostly removed.

The present invention provides a conductive polymer layer using the conductive polymer composition and an organic photoelectric device including the same. The photoelectric device may be a device using photoelectric effect such as an organic electric field light emitting device, an organic solar cell, an organic transistor, and an organic memory device.

Hereinafter, the case that the conductive polymer composition according to the present invention is applied to an organic electric field light emitting device is described.

In the organic electric field light emitting device, the conductive polymer composition is used in a charge injection layer, that is, a hole or electron injection layer (EIL). The light emitting intensity and the efficiency of organic electric field light emitting device are increased by uniformly and efficiently injecting holes and electrons.

Also, in the case of an organic solar cell, the conductive polymer layer composition of the present invention is used as an electrode or an electrode buffer layer to thereby increase quantum efficiency. In the case of an organic transistor, it can be used as an electrode material in a gate or source-drain electrode.

Of the organic photoelectric devices, a structure of an organic electric field light emitting device and a method of manufacturing the same using the conductive polymer layer composition are described.

FIGS. 1A to 1D are schematic cross-sectional views of stacking structures of the organic electric field light emitting devices according to preferable embodiments of the present invention.

The organic electric field light emitting device of FIG. 1A includes a light emission layer 12 formed above a first electrode 10, a hole injection layer (HIL) 11 including the conductive polymer composition of the present invention disposed between the first electrode 10 and the light emission layer, a hole blocking layer (HBL) 13 on top of the light emission layer 12, and a second electrode 14 on top of the hole blocking layer (HBL) 13. The hole injection layer (HIL) 11 may be referred to as a buffer layer.

The organic electric field light emitting device of FIG. 1B has the same stacking structure as that of FIG. 1A, except that an electron transport layer (ETL) 15 is formed instead of the hole blocking layer (HBL) 13 on top of the light emission layer 12.

The organic electric field light emitting device of FIG. 1C has the same stacking structure as that of FIG. 1A, except that a dual layer of the hole blocking layer (HBL) 13 and the electron transport layer (ETL) 15 sequentially stacked therein is formed on top of the light emission layer 12.

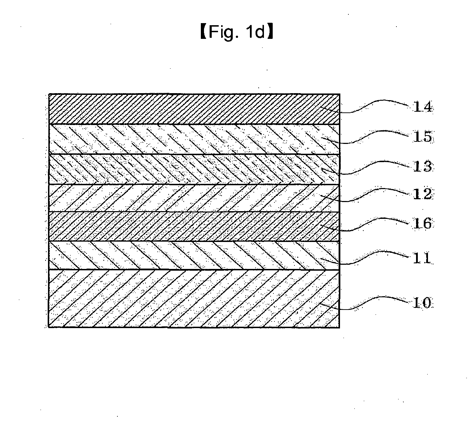

The organic electric field light emitting device of FIG. 1D has the same structure as that of FIG. 1C, except that a hole transport layer (HTL) 16 is formed between the hole injection layer (HIL) 11 and the light emission layer 12. Herein, the hole transport layer (HTL) 16 suppresses permeation of impurities from the hole injection layer (HIL) 11 to the emission layer 12.

The organic electric field light emitting device having the stacking structure of FIGS. 1A to 1D can be fabricated through a general fabrication method.

First, a patterned first electrode 10 is formed on a substrate (not shown).

The substrate is a generally-used substrate for an organic electric field light emitting device, and may be a glass substrate or a transparent plastic substrate having excellent general transparence, surface smoothness, handling ease, and water repellency.

The substrate has a thickness of 0.3 to 1.1 mm.

Materials for forming the first electrode 10 are not specifically limited. When the first electrode is a cathode, the cathode is formed using conductive metals or oxides thereof that easily performs hole injection. Examples of the materials include indium tin oxide (ITO), indium zinc oxide (IZO), nickel (Ni), platinum (Pt), gold (Au), iridium (Ir), and so on.

The substrate including the first electrode 10 is cleaned and is subjected to UV ozone treatment.

An organic solvent such as isopropanol (IPA), acetone, and the like may be used for the cleaning process.

The hole injection layer (buffer layer) 11 is formed on the first electrode 10 of the cleaned substrate, and includes the conductive polymer composition of the present invention.

The formation of the hole injection layer 11 reduces contact resistance between the first electrode 10 and the light emission layer 12, and at the same time improves hole transfer capability of the first electrode 10 toward the light emission layer 12. Thus, the driving voltage and life-span characteristics of the device can be generally improved.

The hole injection layer 11 is formed by dissolving the conductive polymer of the present invention to thereby prepare a composition, spin-coating the upper part of the first electrode 10 with the prepared composition, and drying the composition.

Herein, the thickness of the hole injection layer 11 may preferably range from 5 to 200nm, and more preferably from 20 to 100nm.

When the thickness of the hole injection layer 11 falls in the range, the hole injection can be sufficiently performed, and the light transmission can be maintained at a good level.

A light emission layer 12 is disposed on the hole injection layer 11. The light emission layer material is not specifically limited.

Examples of the material include an oxadiazole dimer dye Bis-DAPOXP), spiro compounds (Spiro-DPVBi, Spiro-6P), triarylamine compounds, bis(styryl)amine (DPVBi, DSA), Flrpic, CzTT, anthracene, TPB, PPCP, DST, TPA, OXD-4, BBOT and AZM-Zn (blue-emitting), coumarin 6, C545T, quinacridone, and Ir(ppy)3 (green-emitting), DCM1, DCM2, Eu(thenoyltrifluoroacetone)3 (Eu(TTA)3 and butyl-6-(1,1,7,7-tetramethyljulolidyl-9-enyl)-4H-pyran (DCJTB) (red-emitting), and the like.

In addition, polymer light emitting materials may be used. The polymer light emitting materials include polymers such as phenylene-based, phenylene vinylene-based, thiophene-based, fluorine-based, and spiro-fluorene-based polymers or nitrogen-included aromatic compounds, but are not limited thereto.

The thickness of the light emission layer 12 may range from 10 to 500nm, and more preferably from 50 to 120nm. When the thickness of the light emission layer 12 falls in the range, leakage current amount and driving voltage increase can be appropriately maintained, and this effectively increases the life-span.

A dopant may be added to the composition for forming the light emission layer.

The content of the dopant varies according to the material used for forming the light emission layer, but generally the content of the dopant may range from 30 to 80 parts by weight with respect to 100 parts by weight of the material for forming a light emission layer (total weight of host and dopant).

When the content of the dopant falls in the range, the light emitting characteristics of the EL device can be effectively maintained. Examples of the dopant include an arylamine, peryl-based compounds, pyrrole-based compounds, hydrazone-based compounds, carbazole-based compounds, stilbene-based compounds, starburst-based compounds, and oxadiazole-based compounds.

A hole transport layer (HTL) 16 may be optionally formed between the hole injection layer (HIL) 11 and the light emission layer 12.

A material for forming the hole transport layer (HTL) is not specifically limited. However, it may include at least one selected from the group consisting of compounds including a carbazole and/or an arylamine, which transport holes, phthalocyanine-based compounds, and triphenylene derivatives.

Examples of the hole transport layer (HTL) may include at least one material selected from the group consisting of 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalen-1-yl)-N,N'-diphenyl benzidine (α-NPD), N,N'-diphenyl-N,N'-bis(1-naphthyl)-(1,1'-biphenyl)-4,4'-diamine (NPB), IDE320 (Idemitsu Kosan Co., Ltd.), poly(9,9-dioctylfluorene-co-N-(4-butylphenyl)diphenylamine) (TFB), and poly(9,9-dioctylfluorene-co-bis-(4-butylphenyl-bis-N,N-phenyl-1,4-phenylene diamine (PFB), but is not limited thereto.

The hole transport layer 16 may preferably have a thickness ranging from 1 to 100 nm, and more preferably from 5 to 50 nm.

When the thickness of the hole transport layer 16 falls in the range, the hole transport layer 16 can maintain sufficient hole transport capability and an appropriate level of driving voltage.

A hole blocking layer 13 and/or an electron transport layer 15 may be disposed on the light emission layer 12 through a deposition or spin coating method. The hole blocking layer 13 prevents excitons formed in a light emitting material from transferring to the electron transport layer 15, or it prevents holes from transferring to the electron transport layer 15.

Examples of a material for forming the hole blocking layer 13 include a phenanthroline-based compound represented by the following Chemical Formula 9 (e.g., BCP of the UDC Company), an imidazole-based compound represented by the following Chemical Formula 10, a triazole-based compound represented by the following Chemical Formula 11, an oxadiazole-based compound (e.g., a commercial product PBD) represented by the following Chemical Formula 12, an aluminum complex (UDC Company), and the like.

The hole blocking layer has a thickness of 5nm to 100nm, and the electron transport layer has a thickness of 5nm to 100nm. When the thickness of the hole blocking layer and electron transport layer is within the above range, electron transport or hole blocking performance is sufficient.

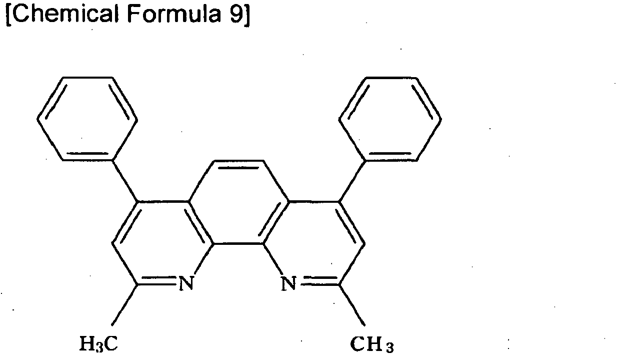

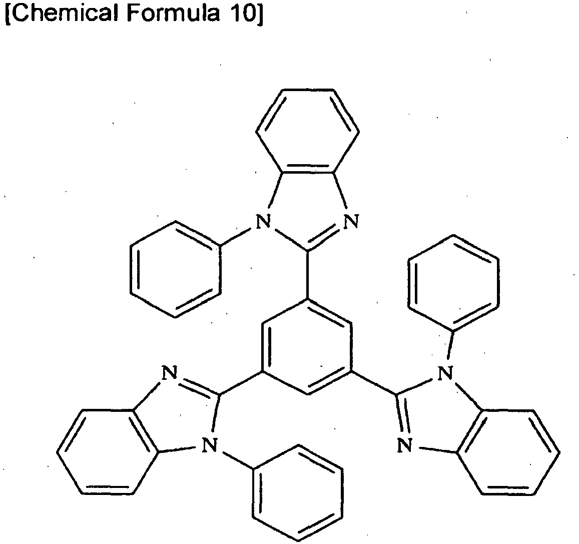

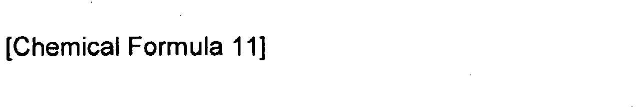

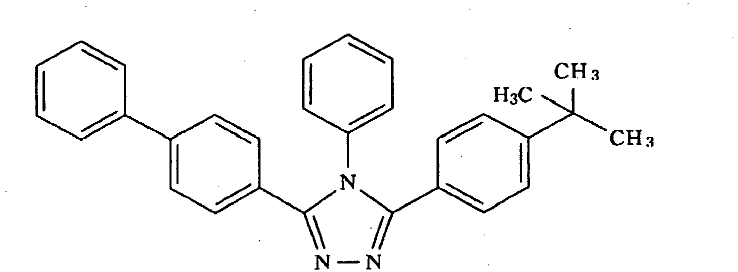

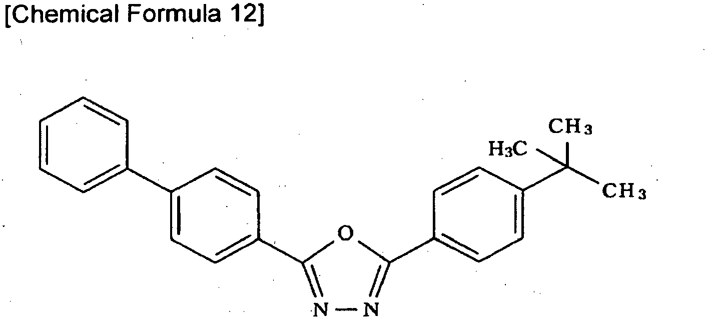

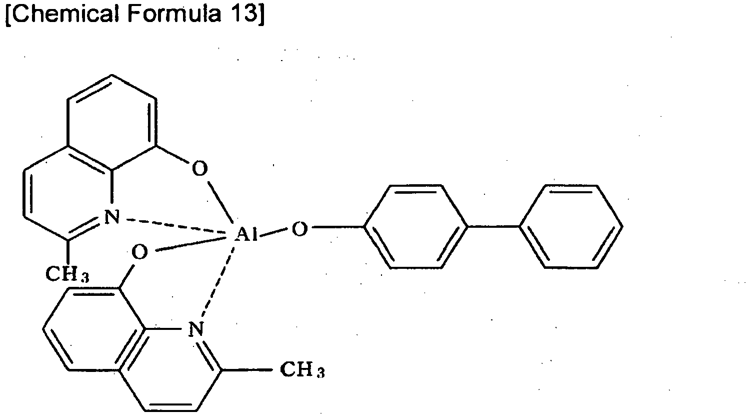

The electron transport layer ETL 15 includes a material selected from oxazole-based compounds, iso-oxazole-based compounds, triazole-based compounds, isothiazole-based compounds, oxadiazole-based compounds, thiadiazole-based compounds, perylene-based compounds represented by Chemical Formula 14, aluminum complexes (Alq3 (tris(8-quinolinolato)-aluminum)) represented by Chemical Formula 15, BAlq represented by Chemical Formula 16, SAlq represented by Chemical Formula 17, Almq3 represented by Chemical Formula 18, and a gallium complex (Gaq'2OPiv) represented by Chemical Formula 19, Gaq'20Ac represented by Chemical Formula 20, 2(Gaq'2) represented by Chemical Formula 21, and the like.

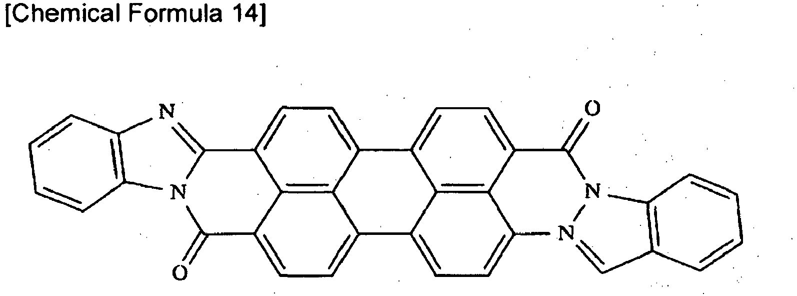

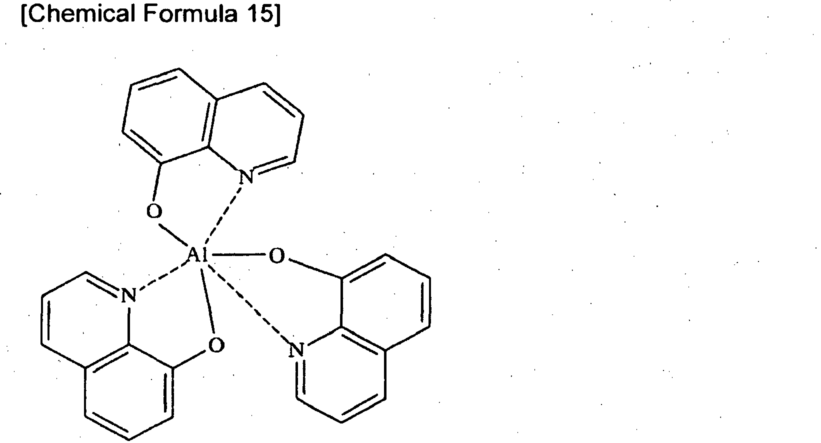

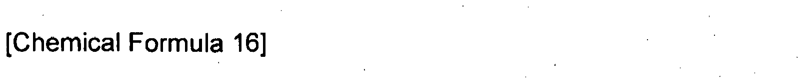

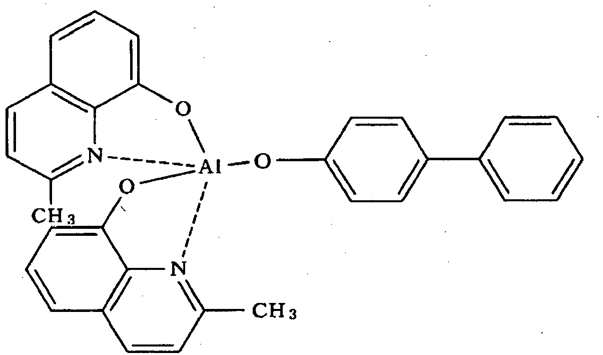

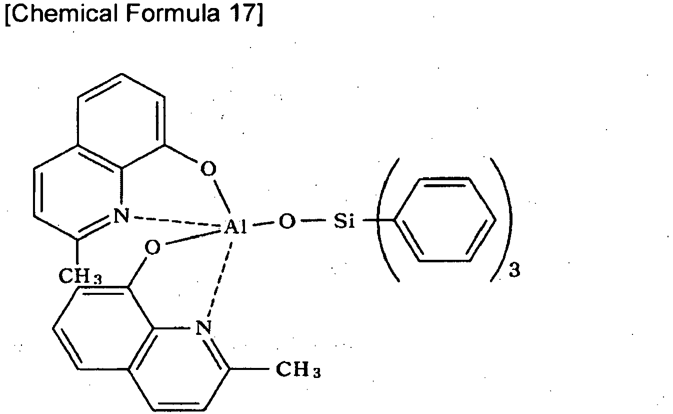

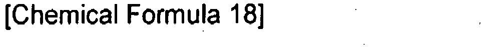

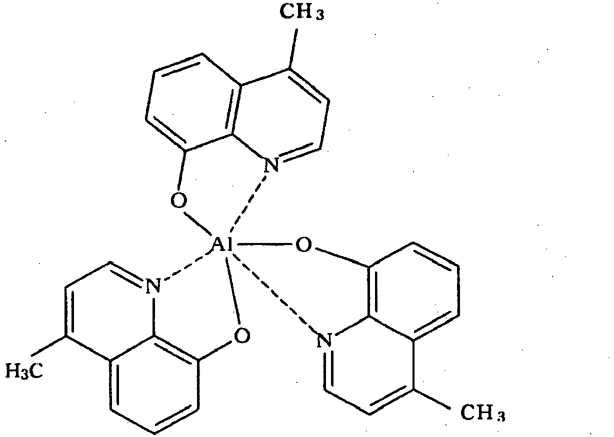

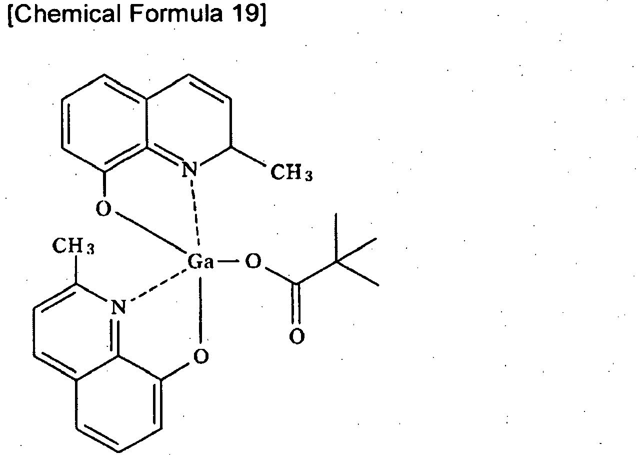

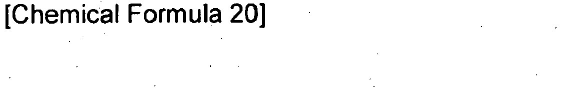

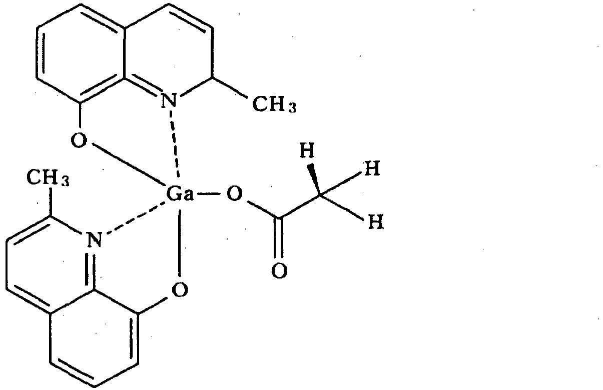

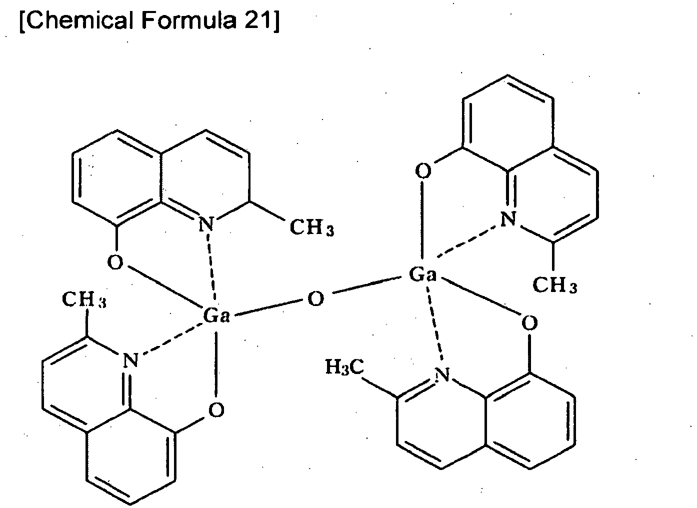

The second electrode 14 is disposed on the stacking structure fabricated as above, and the resulting material is sealed to thereby complete the fabrication of an organic electric field light emitting device.

The materials for forming the second electrode 14 are not specifically restricted, but the materials may be metals with a small work function, such as Li, Cs, Ba, Ca, Ca/Al, LiF/Ca, LiF/Al, BaF₂/Ca, Mg, Ag, Al, or alloys thereof, or multi-layers thereof. The thickness of the second electrode 14 may range from 50 to 3000 A.

The fabrication of an organic electric field light emitting device does not require a specific apparatus or method, and the organic electric field light emitting device of the present invention may be fabricated through a method of fabricating an organic electric field light emitting device using a typical conductive polymer composition.

Hereinafter, exemplary embodiments of the present invention are illustrated to show that a conductive polymer may suppress moisture absorption, decrease a concentration of polyacid in a molecule and agglomeration among molecules and thus, accomplish excellent thin film characteristic and storage stability as well as improve efficiency and life-span of an organic photoelectric device. A person having ordinary skills in this art can sufficiently understand parts of the present invention that are not specifically described.

### Example

### Example 1: Preparation of ionic salt represented by Chemical Formula I-1

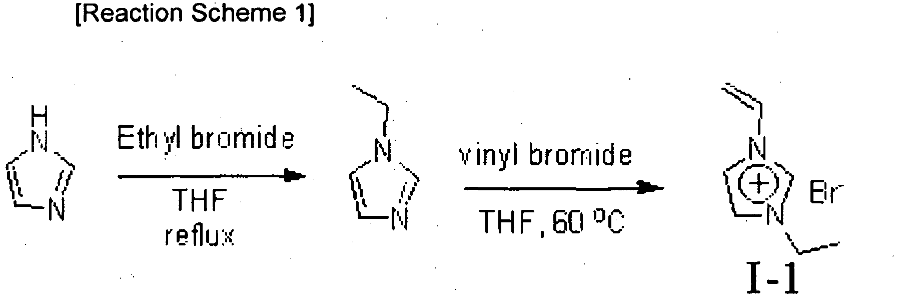

10 g of Ethyl bromide made by Sigma-Aldrich Co., Ltd. and 6 g of imidazole were put in 100 mL of THF under a nitrogen atmosphere, and the mixture was agitated for 8 hours. The reactant was extracted with dichloromethane and four times washed with water. The extracted solution was treated with anhydrous magnesium sulfate to remove extra moisture therefrom. Then, the reactant was filtered, and a solvent was removed therefrom using a rotary evaporator. The resulting product was absorbed in alumina powder and then, developed with dichloromethane, preparing 7 g of yellow liquid N-ethylimidazole.

7 g of the N-ethylimidazole was dissolved in 60 mL of THF, and 9 g of vinyl bromide was added thereto in a dropwise fashion. The mixture was agitated at 60°C for about 8 hours and concentrated under a reduced pressure to remove vinyl bromide and a solvent therefrom. The resulting reactant was treated through an alumina gel column and with dichloromethane, obtaining 13 g of desired yellow liquid I-1.

Element analysis: calc. C: 41.40, H: 5.46, N: 13.79

found C: 41.37, H: 5.42, N: 13.81

### Example 2: Preparation of ionic salt represented by Chemical Formula I-2

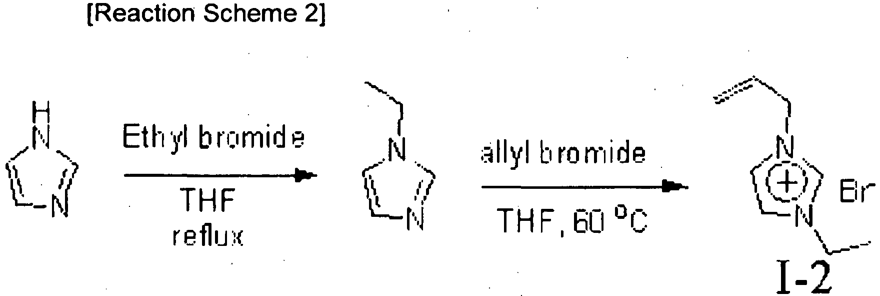

10 g of ethyl bromide made by Sigma-Aldrich Co., Ltd. and 6 g of imidazole were put in 100 mL of THF under a nitrogen atmosphere. The mixture was agitated for 8 hours. The reactant was extracted with dichloromethane and four times washed with water. The extracted solution was treated with anhydrous magnesium sulfate to remove extra moisture therefrom and filtered, and a solvent was removed therefrom using a rotary evaporator. The resulting reactant was absorbed in alumina powder and developed with dichloromethane, obtaining 7 g of light yellow liquid N-ethylimidazole.

7 g of the N-ethylimidazole was dissolved in 60 mL of THF, and 10 g of allyl bromide was added thereto in a dropwise fashion. The mixture was agitated at 60°C for about 8 hours and concentrated under a reduced pressure to remove allyl bromide and a solvent therefrom. The resulting reactant was treated through an alumina gel column and with dichloromethane, obtaining 15 g of light yellow liquid I-2.

Element analysis: calc. C: 44.26, H: 6.04, N: 12.90

found C: 44.30, H: 5.99, N: 12.88

### Example 3: Preparation of ionic salt represented by Chemical Formula I-3

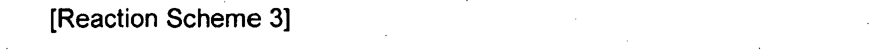

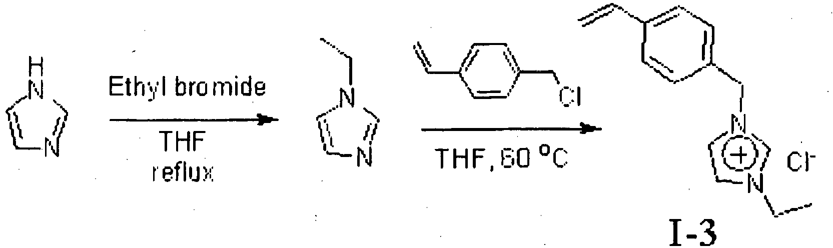

10 g of ethyl bromide made by Sigma-Aldrich Co., Ltd. and 6 g of imidazole were put in 100 mL of THF under a nitrogen atmosphere, and the mixture was agitated for 8 hours. The reactant was extracted with dichloromethane and four times washed with water. The extracted solution was treated with anhydrous magnesium sulfate to remove extra moisture therefrom and filtered, and a solvent was removed therefrom using a rotary evaporator. The resulting reactant was absorbed in alumina powder and developed with dichloromethane, obtaining 7 g of light yellow liquid N-ethylimidazole.

7 g of the N-ethylimidazole was dissolved in 60 mL of THF, and 10 g of 4-vinylbenzyl chloride was added thereto in a dropwise fashion. The mixture was agitated at 60°C for about 8 hours and concentrated under a reduced pressure to remove extra allyl bromide and a solvent therefrom. The resulting reactant was treated through an alumina gel column and with dichloromethane, obtaining 15 g of light yellow liquid I-3 with high viscosity.

Element analysis: calc. C: 44.26, H: 6.04, N: 12.90

found C: 44.30, H: 5.99, N: 12.88

### Example 4: Preparation of ionic salt represented by Chemical Formula 1-4

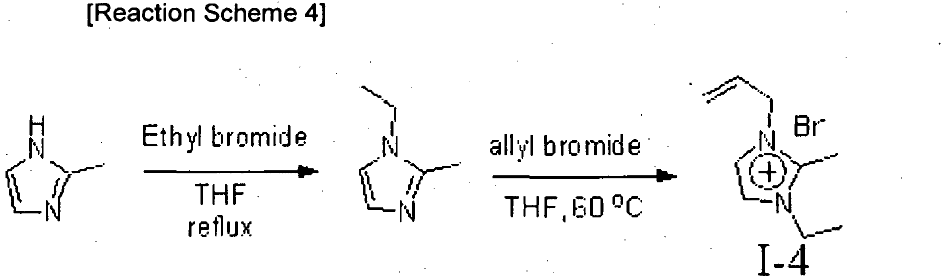

9.5 g of ethyl bromide made by Sigma-Aldrich Co., Ltd. and 6 g of 2-Methylimidazole were put in 100 mL of THF under a nitrogen atmosphere, and the mixture was agitated for 8 hours. The reactant was extracted with dichloromethane and four times washed with water. The extracted solution was treated with anhydrous magnesium sulfate to remove extra moisture therefrom, and a solvent was removed therefrom using a rotary evaporator. The reactant was absorbed in alumina powder and developed with dichloromethane, obtaining 7 g of light yellow liquid 2-methyl-N-ethylimidazole.

7 g of the N-ethylimidazole was dissolved in 60 mL of THF, and 10 g of allyl bromide was added thereto in a dropwise fashion. The mixture was agitated at 60°C for about 8 hours and concentrated under a reduced pressure to remove extra allyl bromide and a solvent. The resulting reactant was treated through an alumina gel column and with dichloromethane, obtaining 15 g of light yellow liquid I-4 with a high viscosity.

Element analysis: calc. C: 44.77, H: 6.54, N: 12.12

found C: 44.73, H: 6.59, N: 12.14

### Example 5: Preparation of ionic salt represented by Chemical Formula 1-5

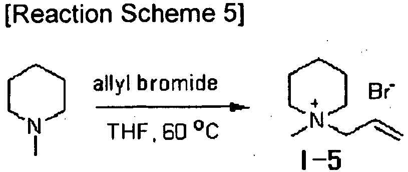

5 g of N-methylpiperidine was dissolved in 60 mL of THF, and 8 g of allyl bromide was added thereto in a dropwise fashion. The mixture was agitated at 60°C for about 8 hours and concentrated under a reduced pressure to remove extra allyl bromide and a solvent. The resulting reactant was treated through an alumina gel column and with dichloromethane, obtaining 12 g of light yellow liquid I-5 with high viscosity.

### Example 6: Preparation of ionic salt represented by Chemical Formula I-1-A

The ionic salt I-1 according to Example 1 was treated with lithium bistrifluoromethanesulfonamide and LiTFSI (LiN(SO₂CF₃)₂) to transfer a halogen anion to ⁻N((SO₂CF₃)₂. The transfer process is as follows.

10 mmol of the ionic salt was dissolved in 300 mL of acetone in a 500 mL round-bottomed flask, and 10 mmol of LiTFSI made by Fluorochem Inc. was added thereto in a dropwise fashion. The mixture was agitated for about 3 hours. The produced white powder was filtered and removed, and the reactant dissolved in a solvent was concentrated under a reduced pressure, obtaining light yellow liquid. The light yellow liquid was treated through an alumina gel column and with dichloromethane, obtaining light liquids substituted with an anion and having high viscosity I-1-A to I-4-A.

### Example 7: Preparation of ionic salt represented by Chemical Formula I-2-A

Ionic salt I-2-A was prepared according to the same method as Example 6 except for using the ionic salt I-2 according to Example 2 instead of the ionic salt I-1 according to Example 1.

### Example 8: Preparation of ionic salt represented by Chemical Formula I-3-A

Ionic salt I-3-A was prepared according to the same method as Example 6 except for using the ionic salt I-3 according to Example 2 instead of the ionic salt I-1 according to Example 1.

### Example 9: Preparation of ionic salt represented by Chemical Formula I-4-A

Ionic salt I-4-A was prepared according to the same method as Example 6 except for using the ionic salt I-4 according to Example 2 instead of the ionic salt I-1 according to Example 1.

Each ionic salt according to Examples 6 to 9 were represented by the following Chemical Formulas 23 to 26.

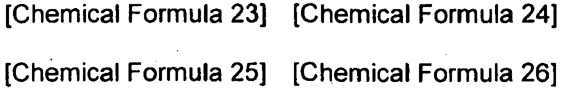

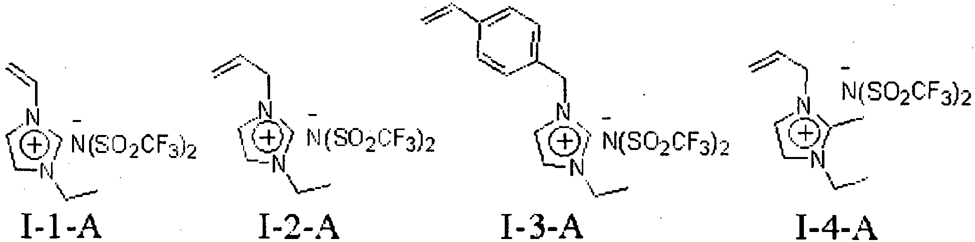

### Example 10: Synthesis of doped polymer

### Step1: Synthesis of copolymer

12g of sodium styrenesulfonate (SSNa) (Sigma Aldrich Co., Ltd.) and 3g of the ionic salt I-1-A (in an amount of 12.7 mol% based on the entire weight of sodium styrenesulfonate (SSNa)) were heated and completely dissolved in 250 mL of dimethylsulfoxide (DMSO). Next, a solution prepared by dissolving 0.3g of azobisisobutyronitrile (AIBN) in dimethylsulfoxide (DMSO) was added to the above solution in a dropwise fashion and polymerized for greater than or equal to 48 hours.

The obtained reactant was precipitated with acetone, allowed to stand at a room temperature, and filtered, obtaining a copolymer. Herein, the copolymer had a polymer mole ratio of 8:1 and Mn = 24,000 and Mw = 12,100.

### Step2: Acidification and NaCl removal, and polymer purification

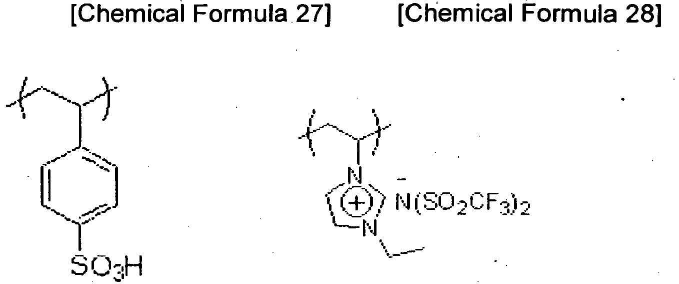

The copolymer obtained in the first step was developed a using cation-based resin Amberite®IR-120 column, which is activated with H+, obtaining a copolymer including polymers represented by Chemical Formulas 27 and 28. After this process was greater than or equal to three times repeated, NaCl salts produced there and remaining in a small amount were sufficiently removed a Prep/Scale®TFF membrane made by Millipore Co., obtaining a copolymer including pure polymers of Chemical Formulas 27 and 28. Herein, the obtained doped polymer had the same mole ratio as the Step 1. The copolymer had a molecular weight of Mn = 23,600 and Mw = 12,700.

### Example 11: Synthesis of doped polymer

### Step 1: Synthesis of copolymer

12g of sodium styrenesulfonate (SSNa) (Sigma Aldrich Co., Ltd.) and 3g of the ionic salt I-2-A (used in an amount of 12.3 mol% based on the amount of the sodium styrenesulfonate (SSNa)) were heated and completely dissolved in 250 mL of dimethylsulfoxide (DMSO). Next, the solution was added to a solution prepared by dissolving 0.3g of azobisisobutyronitrile (AIBN) in dimethylsulfoxide (DMSO) in a dropwise fashion and then, polymerized for greater than or equal to 48 hours.

The obtained reactant was precipitated with acetone, allowed to stand at a room temperature, and filtered, obtaining a copolymer. Herein, the copolymer had a polymer mole ratio of 8:1 and Mn = 23,500 and Mw = 10,100.

### Step 2: Acidification, NaCl removal, and polymer purification

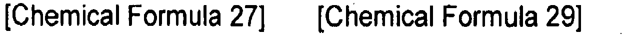

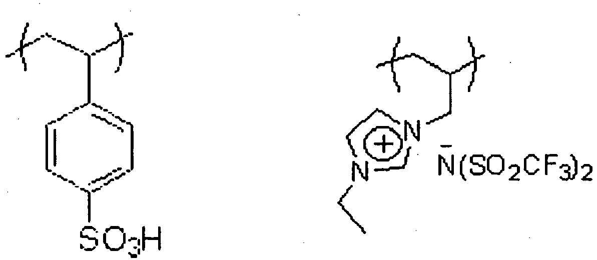

The copolymer obtained in the first step was developed using a cation-based resin Amberite®IR-120 column, which was activated with H+, obtaining a copolymer including polymers of Chemical Formulas 27 and 29. After this process was greater than or equal to three times repeated, NaCl salts produced there and remaining in a small amount were sufficiently removed, obtaining a copolymer including polymers of Chemical Formulas 27 and 29. Herein, the obtained doped polymer had the same mole ratio as the Step 1. The copolymer had a molecular weight of Mn = 23,600 and Mw = 11,000.

### Example 12: Synthesis of doped polymer

### Step 1: Synthesis of copolymer

12g of sodium styrenesulfonate (SSNa) (Sigma Aldrich Co. Ltd.) and 3g of the ionic salt I-3-A (used in an amount of 12.3 mol% based on the amount of sodium styrenesulfonate (SSNa)) were heated and completely dissolved in 250 mL of dimethylsulfoxide (DMSO). Next, a solution prepared by dissolving 0.3g of azobisisobutyronitrile (AIBN) in dimethylsulfoxide (DMSO) was added to the solution in a dropwise fashion and polymerized for greater than or equal to 48 hours.

The obtained reactant was precipitated with acetone, allowed to stand at a room temperature, and filtered, obtaining a copolymer. Herein, the copolymer had a polymer mole ratio of 8:1 and Mn = 23,500 and Mw = 10,100.

### Step 2: Acidification, NaCl removal, and polymer purification

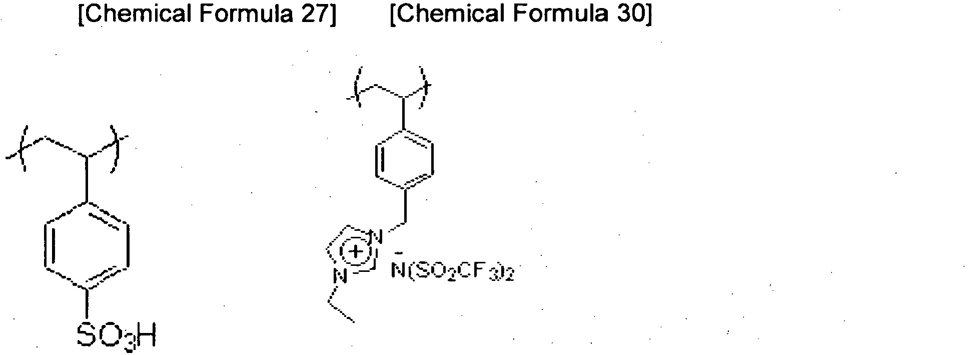

The copolymer obtained in the first step was developed using a cation-based resin Amberite®IR-120 column, which was activated with H+, obtaining a copolymer including polymers of Chemical Formulas 27 and 30. After the process was greater than or equal to 3 times repeated, NaCl salts produced there and remaining in a small amount were sufficiently removed using a Prep/Scale®TFF membrane made by Millipore Co., obtaining a copolymer including polymers of Formulas 27 and 30. Herein, the obtained doped polymer had the same mole ratio as the Step 1. The copolymer had a molecular weight of Mn = 23,600 and Mw = 11,000.

### Example 13: Synthesis of doped polymer

### Step 1: Synthesis of copolymer

12g of sodium styrenesulfonate (SSNa) (Sigma Aldrich Co., Ltd.) and 3.1g of the ionic salt I-4-A (used in an amount of 12.3 mol% based on the amount of the sodium styrenesulfonate (SSNa)) were heated and completely dissolved in 250 mL of dimethylsulfoxide (DMSO). Next, a solution prepared by dissolving 0.3g of azobisisobutyronitrile (AIBN) in dimethylsulfoxide (DMSO) was added to the solution in a dropwise fashion and polymerized for greater than or equal to 48 hours.

The obtained reactant was precipitated with acetone, allowed to stand at a room temperature, and filtered, obtaining a copolymer. Herein, the copolymer had a polymer mole ratio of 8:1 and Mn = 22,100 and Mw = 10,500.

### Step 2: Acidification, NaCl removal, and polymer purification

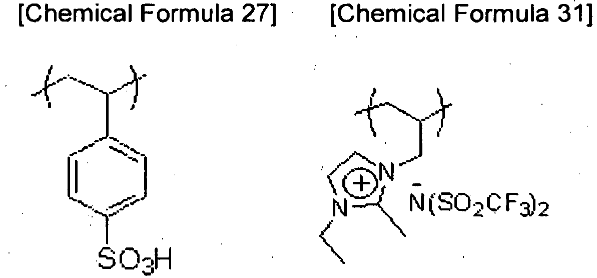

The copolymer obtained in the first step was developed using a cation-based resin Amberite®IR-120 column, which was activated with H+, obtaining a copolymer including polymers of Chemical Formulas 27 and 31. After this process was greater than or equal to three times repeated, a Prep/Scale®TFF membrane made by Millipore Co. was used to remove NaCl salts produced there and remaining in a small amount, obtaining a copolymer including polymers of Chemical Formulas 27 and 31. Herein, the obtained doped polymer had the same mole ratio as the Step 1. The copolymer had a molecular weight of Mn = 23,500 and Mw = 12,500.

### Example 14: Fabrication of organic photoelectric device

A 154ψ/cm² (1200A) ITO glass substrate (Corning Inc.) was cut to be width×length×thickness of 50mm × 50mm × 0.7mm and ultrasonic wave-cleaned in isopropyl alcohol and pure water for 5 minutes, respectively and UV, ozon-cleaned for 30 minutes.

Then, the conductive polymer compound composition according to Example 10 was spin-coated to form a 50 nm-thick hole injection layer (HIL) on the substrate.

On the hole injection layer (HIL), a 70 nm-thick emission layer was formed of a red light emitting polymer, and on the emission layer, 2 nm LiF and 100 nm Al were formed as a second electrode, fabricating an organic photoelectric device.

### Example 15: Fabrication of organic photoelectric device

An organic photoelectric device was fabricated according to the same method as Example 14 except for using the conductive polymer according to Example 11 instead of the conductive polymer compound according to Example 10.

### Example 16: Fabrication of organic photoelectric device

An organic photoelectric device was fabricated according to the same method as Example 14 except for using the conductive polymer according to Example 12 instead of the conductive polymer compound according to Example 10.

### Example 17: Fabrication of organic photoelectric device

An organic photoelectric device was fabricated according to the same method as Example 14 except for using the conductive polymer according to Example 13 instead of the conductive polymer compound according to Example 10.

### Comparative Example 1: Fabrication of organic photoelectric device

An organic photoelectric device was fabricated according to the same method as Example 14 except for using a CH8000 conductive polymer made by H.C Storck Ltd. instead of the conductive polymer compound according to Example 10.

### Experimental Examples

### Experiment Method

### (1) Measurement of thin film on the surface

The copolymers according to Examples 10 to 13 were respectively spin-coated to form a film in a 15 X 15µm region on an ITO substrate using XE-100 made by Park system Corp. Then, the 10 X 10 µm region of the film was measured regarding surface average roughness thereof.

### (2) Water filterability of copolymer and conductive polymer

10 ml of each copolymer according to Examples 10 to 13 was filtered using a 0.45 µm syringe disk filter made of a PVDF material (Millipore Co.)

### (3) Efficiency characteristic of organic photoelectric device

The organic photoelectric devices according to Examples 14 to 17 were measured regarding efficiency in a method of measuring I-V-L using Keithley 2400 (Keithle Instrument Inc.) and CS-1000A (Minolta Co., Ltd.).

### Experiment Result

The following Table 1 provides surface status of thin films and water filterability of conductive polymers.

As shown in the following Table, the copolymers had excellent water filterability and very low roughness.

**(Table 1)**

| Samples | Filterability | Roughness (nm) | Conductive polymer |
|---|---|---|---|
| Example 10 | 10 mL | 1.4 | polythiophene |
| Example 11 | 10 mL | 1.3 | polythiophene |
| Example 12 | 10 mL | 1.2 | polythiophene |
| Example 13 | 10 mL | 1.8 | polythiophene |

The following Table 2 provides efficiency characteristic of organic photoelectric devices.

As shown in the following Table 2, the organic photoelectric devices of all Examples had better luminous efficiency than Comparative Example 1 and much better electric power efficiency due to low driving voltage than the organic photoelectric device according to Comparative Example 1.

**(Table 2)**

| Nos. | Samples | Conductive polymer | Efficiency (at 1000nit) | | |
|---|---|---|---|---|---|
| | | | Driving voltage (Vd) | Luminous efficiency (cd/A) | Electric power efficiency (Im/W) |
| 1 | Example 14 | Example 10 | 6.8 | 5.6 | 2.6 |
| 2 | Example 15 | Example 11 | 6.7 | 6.3 | 2.8 |
| 3 | Example 16 | Example 12 | 6.9 | 6.0 | 2.8 |
| 4 | Example 17 | Example 13 | 7.3 | 6.4 | 2.1 |
| 5 | Comparative Example 1 | CH8000 (H.C Storck) | 7.8 | 4.2 | 1.7 |

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims. Therefore, the aforementioned embodiments should be understood to be exemplary but not limiting the present invention in any way.

## Claims

1. A conductive polymer doped with a polyacid copolymer represented by the following Chemical Formula 1: 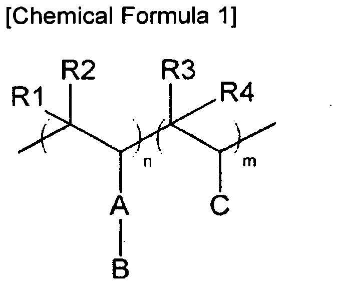 wherein, in Chemical Formula 1,
A is a carbon-based group, and is selected from the group consisting of a substituted or unsubstituted C1 to C30 alkyl group; a substituted or unsubstituted C1 to C30 heteroalkyl group; a substituted or unsubstituted C1 to C30 alkoxy group; a substituted or unsubstituted C1 to C30 heteroalkoxy group; a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group; a substituted or unsubstituted C2 to C30 heteroaryloxy group; a substituted or unsubstituted C5 to C20 cycloalkyl group; a substituted or unsubstituted C2 to C30 heterocycloalkyl group; a substituted or unsubstituted C1 to C30 alkylester group; a substituted or unsubstituted C1 to C30 heteroalkylester group; a substituted or unsubstituted C6 to C30 arylester group; and a substituted or unsubstituted C2 to C30 heteroarylester group,
B is an ionic group or a group including an ionic group, wherein the ionic group include a pair of a cation and an anion, the cation is a metal ion of Na⁺, K⁺, Li⁺, Mg²⁺, Zn²⁺, or Al³⁺, H⁺, NH₃⁺, or an organic ion of CH₃(-CH₂-)ₙ (n is a natural number of 1 to 50 ), and the anion is PO3⁻, SO₃⁻, COO⁻, I⁻, or CH₃COO⁻,
C is the cation of an organic ion salt including an anion and a cation,
R1 to R4 are the same or different, and are independently selected from the group consisting of hydrogen, a substituted or unsubstituted C1 to C10 alkyl, a substituted or unsubstituted C6 to C20 aryl, and a substituted or unsubstituted C3 to C20 heteroaryl,
0<m ≤ 10,000,000, 0<n<10,000,000, and 0.0001 ≤ m/n ≤ 100,
wherein C is one of the following Chemical Formulae 2 to 5: 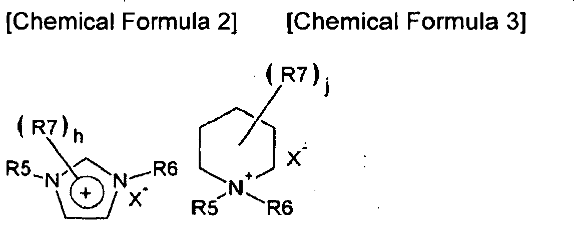 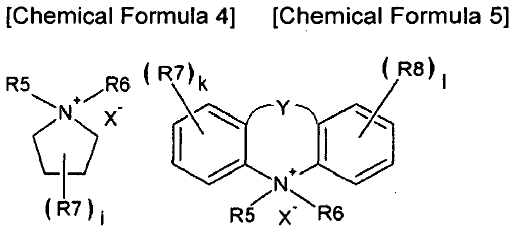 wherein, in Chemical Formulae 2 to 5,
one of R5 to R6 is selected from the group consisting of a substituted or unsubstituted C1 to C30 alkylene group, a substituted or unsubstituted C1 to C30 heteroalkylene group, a substituted or unsubstituted C1 to C30 alkoxylene group, a substituted or unsubstituted C1 to C30 heteroalkoxylene group, a substituted or unsubstituted C6 to C30 arylene group, a substituted or unsubstituted C6 to C30 arylalkylene group, a substituted or unsubstituted C2 to C30 heteroarylene group, a substituted or unsubstituted C2 to C30 heteroarylalkylene group, a substituted or unsubstituted C5 to C20 cycloalkylene group, and a substituted or unsubstituted C2 to C30 heterocycloalkylene group, and is bound to a main chain at its one end, and
the rest one of R5 to R8 is the same or different is independently selected from the group consisting of hydrogen, a substituted or unsubstituted C1 to C30 alkyl group, a substituted or unsubstituted C1 to C30 heteroalkyl group, a substituted or unsubstituted C1 to C30 alkoxy group, a substituted or unsubstituted C1 to C30 heteroalkoxy group, a substituted or unsubstituted C6 to C30 aryl group, a substituted or unsubstituted C6 to C30 arylalkyl group, a substituted or unsubstituted C6 to C30 aryloxy group, a substituted or unsubstituted C2 to C30 heteroaryl group, a substituted or unsubstituted C2 to C30 heteroarylalkyl group, a substituted or unsubstituted C2 to C30 heteroaryloxy group, a substituted or unsubstituted C5 to C20 cycloalkyl group, a substituted or unsubstituted C2 to C30 heterocycloalkyl group, a substituted or unsubstituted C1 to C30 alkylester group, a substituted or unsubstituted C1 to C30 heteroalkylester group, a substituted or unsubstituted C6 to C30 arylester group, and a substituted or unsubstituted C2 to C30 heteroarylester group,
X of X- is selected from the group consisting of F, Cl, Br, I, BF₄, PF₆ and (CnF₂ₙ₊₁SO₂)₂N (n is a natural number of 1 to 50),
Y is selected from the group consisting of -CH₂-, -CR'R"-, -NH-, -NR'-, -O-, - P-, -P=O-, -S-, and -SiR'R"-, wherein R' and R" are the same or different and are independently selected from the group consisting of hydrogen, a substituted or unsubstituted C1 to C10 an alkyl, a substituted or unsubstituted C6 to C20 aryl, and a substituted or unsubstituted C3 to C20 heteroaryl,
h is an integer of 1 to 3,
i is an integer of 1 to 8,
j is an integer of 1 to 10,
k is an integer of 1 to 4, and
I is an integer of 1 to 4.

2. The conductive polymer of claim 1, wherein the conductive polymer is a polymer which is obtained by polymerizing one selected from the group consisting of a monomer of polyphenylene, polyphenylenevinylene, polyaniline, or a derivative thereof represented the following Chemical Formula 6; a monomer of pyrrole represented by the following Chemical Formula 7, a monomer of thiophene or a derivative thereof: 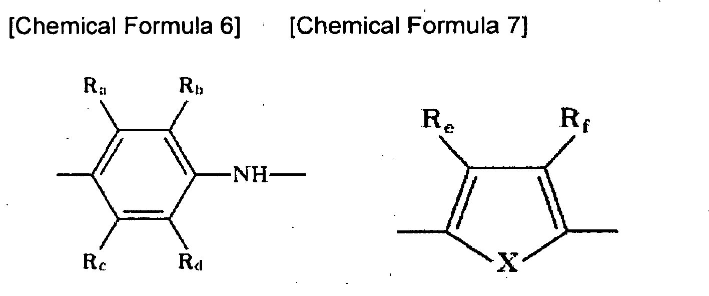 wherein, in Chemical Formulae 6 and 7,
X is NH; or a heteroatom selected from N, O, S, and P bound to a C1 to C20 alkyl group or a C6 to C20 aryl group,
Ra, Rb, Rc, and Rd are the same or different and are independently selected from the group consisting of hydrogen; a C1 to C30 alkyl group; a C1 to C30 heteroalkyl group; a C1 to C30 alkoxy group; a C1 to C30 heteroalkoxy group; a C6 to C30 aryl group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group, and
Re and Rf are the same or different and independently selected from the group consisting of NH; or a heteroatom selected from N, O, S, and P bound to a C1 to C20 alkyl group or a C6 to C20 aryl group; a C1 to C30 alkyl group; a C6 to C30 aryl group; a C1 to C30 alkoxy group; a C1 to C30 heteroalkyl group; a C1 to C30 heteroalkoxy group; a C6 to C30 arylalkyl group; a C6 to C30 aryloxy group; a C6 to C30 arylamine group; a C6 to C30 pyrrole group; a C6 to C30 thiophene group; a C2 to C30 heteroaryl group; a C2 to C30 heteroarylalkyl group; a C2 to C30 heteroaryloxy group; a C5 to C20 cycloalkyl group; a C2 to C30 heterocycloalkyl group; a C1 to C30 alkylester group; a C1 to C30 heteroalkylester group; a C6 to C30 arylester group; and a C2 to C30 heteroarylester group.

3. The conductive polymer of claim 1, wherein the conductive polymer is a polymer obtained by polymerizing a compound represented by the following Chemical Formula 8 as a monomer: 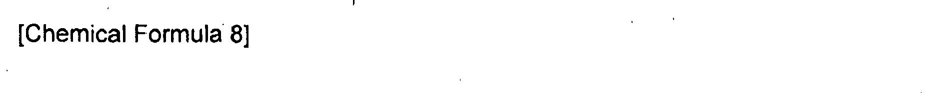 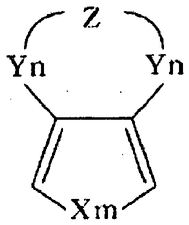 wherein, in Chemical Formula 8,
X is NH, or a heteroatom selected from N, O, S, and P bound to a C1 to C20 alkyl group or a C6 to C20 aryl group,
Y is NH, or a heteroatom selected from N, O, S, and P bound to a C1 to C20 alkyl group or a C6 to C20 aryl group,
m and n are each independently an integer ranging from 0 to 9, and
Z is -(CH₂)ₓ-CRgRh-(CH₂)_{y}, and Rg and Rh are the same or different and independently selected from H, a C1 to C20 alkyl radical, a C6 to C14 aryl radical, and -CH₂-ORi, wherein Ri is selected from the group consisting of H, a C1 to C6 alkyl acid a C1 to C6 alkylester, a C1 to C6 heteroalkyl acid, and a C1 to C6 alkylsulfonic acid.

4. A conductive polymer composition for an organic photoelectric device comprising the conductive polymer according to one of claims 1 to 3 and a solvent.

5. The conductive polymer composition for an organic photoelectric device of claim 4, wherein the solvent is at least one solvent selected from the group consisting of water, alcohol, dimethyl formamide (DMF), dimethylsulfoxide, toluene, xylene, and chlorobenzene.

6. The conductive polymer composition for an organic photoelectric device of claim 4, wherein the conductive polymer composition further comprises a physical cross-linking agent or a chemical cross-linking agent.

7. The conductive polymer composition for an organic photoelectric device of claim 6, wherein the physical cross-linking agent is at least one selected from the group consisting of glycerol, butanol, polyvinylalcohol, polyethyleneglycol, polyethyleneimine, and polyvinylpyrrolidone.

8. The conductive polymer composition for an organic photoelectric device of claim 6, wherein the chemical cross-linking agent is at least one selected from the group consisting of tetraethyloxysilane, polyaziridine, a melamine-based polymer, and an epoxy-based polymer.

9. The conductive polymer composition for an organic photoelectric device of claim 6, wherein the physical cross-linking agent may be included in an amount of 0.001 to 5 parts by weight based on 100 parts by weight of the conductive polymer composition according to claim 6.

10. The conductive polymer composition for an organic photoelectric device of claim 6, wherein the chemical cross-linking agent may be included in an amount of 0.001 to 50 parts by weight by weight based on 100 parts by weight of the conductive polymer composition according to claim 6.

11. A conductive polymer composition layer for an organic photoelectric device formed using the conductive polymer composition one of claims 4 to 10.

12. An organic photoelectric device comprising the conductive polymer composition layer according to claim 11.

## Patentansprüche

1. Leitfähiges Polymer, das mit einem durch die folgende chemische Formel 1 dargestellten Polysäure-Copolymer dotiert ist: 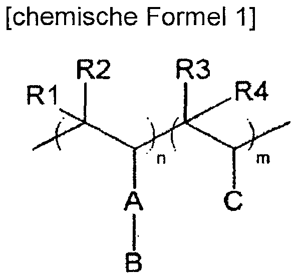 wobei in der chemischen Formel 1
A eine kohlenstoffbasierte Gruppe ist, die ausgwählt ist aus einer substituierten oder unsubstituierten C₁- bis C₃₀-Alkylgruppe, einer substituierten oder unsubstituierten C₁- bis C₃₀-Heteroalkylgruppe, einer substituierten oder unsubstituierten C₁- bis C₃₀-Alkoxygruppe, einer substituierten oder unsubstituierten C₁- bis C₃₀-Heteroalkoxygruppe, einer substituierten oder unsubstituierten C₆- bis C₃₀-Arylgruppe, einer substituierten oder unsubstituierten C₆- bis C₃₀-Arylyalkylgruppe, einer substituierten oder unsubstituierten C₆- bis C₃₀-Aryloxygruppe, einer substituierten oder unsubstituierten C₂- bis C₃₀-Heteroarylgruppe, einer substituierten oder unsubstituierten C₂- bis C₃₀-Heteroarylalkylgruppe, einer substituierten oder unsubstituierten C₂- bis C₃₀-Heteroaryloxygruppe, einer substituierten oder unsubstituierten C₅- bis C₂₀-Cycloalkylgruppe, einer substituierten oder unsubstituierten C₂- bis C₃₀-Heterocycloalkylgruppe, einer substituierten oder unsubstituierten C₁- bis C₃₀-Alkylestergruppe, einer substituierten oder unsubstituierten C₁- bis C₃₀-Heteroalkylestergruppe, einer substituierten oder unsubstituierten C₆- bis C₃₀-Arylestergruppe und einer substituierten oder unsubstituierten C₂- bis C₃₀-Heteroarylestergruppe,
B eine ionische Gruppe oder eine Gruppe mit einer ionischen Gruppe ist, wobei die ionische Gruppe ein Kation/Anion-Paar aufweist, wobei das Kation ein Metallion unter Na⁺, K⁺, Li⁺, Mg²⁺, Zn²⁺ oder Al³⁺, H⁺, NH₃⁺ oder ein organisches Ion CH₃(-CH₂-)n (wobei n eine natürliche Zahl von 1 bis 50 ist), und das Anion PO₃⁻, SO₃⁻, COO⁻, I⁻ oder CH₃COO⁻ ist,
C das Kation eines organischen Ionensalzes ist, das ein Anion und ein Kation enthält,
R1 bis R4 gleich oder verschieden sind und unabhängig ausgewählt sind aus der Gruppe bestehend aus Wasserstoff, einem substituierten oder unsubstituierten C₁- bis C₁₀-Alkyl, einem substituierten oder unsubstituierten C₆- bis C₂₀-Aryl und einem substituierten oder unsubstituierten C₃- bis C₂₀-Heteroaryl,
0 < m ≤ 10000000, 0 < n < 10000000 und 0,0001 ≤ m/n ≤ 100,
wobei C eine der folgenden chemischen Formeln 2 bis 5 ist: 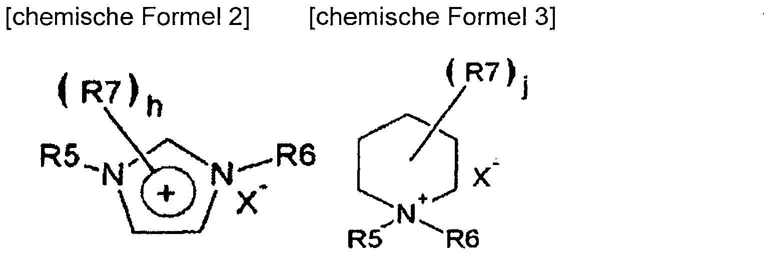 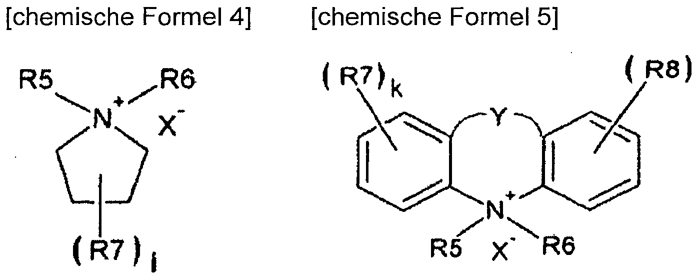 wobei in den chemischen Formeln 2 bis 5
eine der Komponenten R5 bis R6 aus der Gruppe bestehend aus einer substituierten oder unsubstituierten C₁- bis C₃₀-Alkylengruppe, einer substituierten oder unsubstituierten C₁- bis C₃₀-Heteroalkylengruppe, einer substituierten oder unsubstituierten C₁- bis C₃₀-Alkoxylengruppe, einer substituierten oder unsubstituierten C₁- bis C₃₀-Heteroalkoxylengruppe, einer substituierten oder unsubstituierten C₆- bis C₃₀-Arylengruppe, einer substituierten oder unsubstituierten C₆- bis C₃₀-Arylalkylengruppe, einer substituierten oder unsubstituierten C₂- bis C₃₀-Heteroarylengruppe, einer substituierten oder unsubstituierten C₂- bis C₃₀-Heteroarylalkylengruppe, einer substituierten oder unsubstituierten C₅- bis C₂₀-Cycloalkylengruppe und einer substituierten oder unsubstituierten C₂- bis C₃₀-Heterocloalkylengruppe ausgewählt ist und an einem Ende mit einer Hauptgruppe verbunden ist, und
wobei die übrigen der Komponenten R5 bis R8 gleich oder verschieden sind und unabhängig aus der Gruppe bestehend aus Wasserstoff, einer substituierten oder unsubstituierten C₁- bis C₃₀-Alkylgruppe, einer substituierten oder unsubstituierten C₁- bis C₃₀-Heteroalkylgruppe, einer substituierten oder unsubstituierten C₁- bis C₃₀-Alkoxygruppe, einer substituierten oder unsubstituierten C₁- bis C₃₀-Heteroalkoxygruppe, einer substituierten oder unsubstituierten C₆- bis C₃₀-Arylgruppe, einer substituierten oder unsubstituierten C₆- bis C₃₀-Arylalkylgruppe, einer substituierten oder unsubstituierten C₆- bis C₃₀-Aryloxygruppe, einer substituierten oder unsubstituierten C₂- bis C₃₀-Heteroarylgruppe, einer substituierten oder unsubstituierten C₂- bis C₃₀-Heteroarylalkylgruppe, einer substituierten oder unsubstituierten C₂- bis C₃₀-Heteroaryloxygruppe, einer substituierten oder unsubstituierten C₅- bis C₂₀-Cycloalkylgruppe, einer substituierten oder unsubstituierten C₂- bis C₃₀-Heterocycloalkylgruppe, einer substituierten oder unsubstituierten C₁- bis C₃₀-Alkylestergruppe, einer substituierten oder unsubstituierten C₁- bis C₃₀-Heteroalkylestergruppe, einer substituierten oder unsubstituierten C₆- bis C₃₀-Arylestergruppe und einer substituierten oder unsubstituierten C₂- bis C₃₀-Heteroarylestergruppe ausgewählt sind,
X von X- aus der Gruppe bestehend aus F, Cl, Br, I, BF₄, PF₆ und (CnF₂ₙ₊₁SO₂)₂N ausgewählt ist (wobei n eine natürliche Zahl von 1 bis 50 ist),
Y aus der Gruppe bestehend aus -CH₂-, -CR'R"-, -NH-, -NR'-, -O-, -P-, -P=O-, -S- und -SiR'R"- ausgewählt ist, wobei R' und R" gleich oder verschieden sind und unabhängig ausgewählt sind aus der Gruppe bestehend aus Wasserstoff, einem substituierten oder unsubstituierten C₁- bis C₁₀-Alkyl, einem substituierten oder unsubstituierten C₆- bis C₂₀-Aryl und einem substituierten oder unsubstituierten C₃- bis C₂₀-Heteroaryl,
h eine ganze Zahl von 1 bis 3 ist,
i eine ganze Zahl von 1 bis 8 ist,
j eine ganze Zahl von 1 bis 10 ist,
k eine ganze Zahl von 1 bis 4 ist, und
l eine ganze Zahl von 1 bis 4 ist.

2. Leitfähiges Polymer nach Anspruch 1, wobei das leitfähige Polymer ein Polymer, das durch Polymerisation einer Komponente, die aus der Gruppe bestehend aus einem Monomer von Polyphenylen, Polyphenylenvinylen, Polyanilin oder einem Derivat davon ausgewählt wird, das durch die folgende chemische Formel 6 dargestellt ist, ein Monomer von Pyrrol, das durch die nachfolgende chemische Formel 7 dargestellt ist, ein Monomer von Thiophen oder ein Derivat davon ist 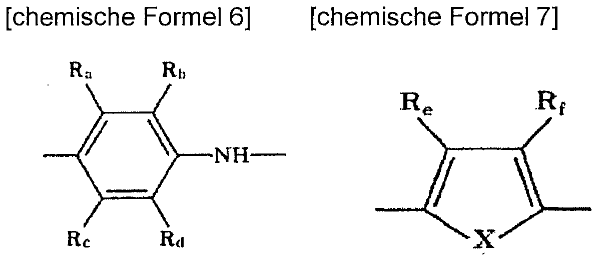 wobei in den chemischen Formeln 6 und 7
X NH oder ein Heteroatom ist, das aus N, O, S und P ausgewählt ist, das mit einer C₁- bis C₂₀-Alkylgruppe oder einer C₆- bis C₂₀-Arylgruppe verbunden ist,
Ra, Rb, Rc und Rd gleich oder verschieden und unabhängig ausgewählt sind aus der Gruppe bestehend aus Wasserstoff, einer C₁- bis C₃₀-Alkylgruppe, einer C₁- bis C₃₀-Heteroalkylgruppe, einer C₁- bis C₃₀-Alkoxygruppe, einer C₁- bis C₃₀-Heteroalkoxygruppe, einer C₆- bis C₃₀-Arylgruppe, einer C₆- bis C₃₀-Arylalkylgruppe, einer C₆- bis C₃₀-Aryloxygruppe, einer C₆- bis C₃₀-Arylamingruppe, einer C₆- bis C₃₀-Pyrrolgruppe, einer C₆- bis C₃₀-Thiophengruppe, einer C₂- bis C₃₀-Heteroarylgruppe, einer C₂- bis C₃₀-Heteroarylalkylgruppe, einer C₂- bis C₃₀-Heteroaryloxygruppe, einer C₅- bis C₂₀-Cycloalkylgruppe, einer C₂- bis C₃₀-Heterocloalkylgruppe, einer C₁- bis C₃₀-Alkylestergruppe, einer C₁- bis C₃₀-Heteroalkylestergruppe, einer C₆- bis C₃₀-Arylestergruppe und einer C₂- bis C₃₀-Heteroarylestergruppe, und
Re und Rf gleich oder verschieden sind und unabhängig ausgewählt werden aus der Gruppe bestehend aus NH oder einem Heteroatom, das aus N, O, S und P besteht, das mit einer C₁- bis C₂₀-Alkylgruppe oder einer C₆- bis C₂₀-Arylgruppe verbunden ist; einer C₁- bis C₃₀-Alkylgruppe; einer C₆- bis C₃₀-Arylgruppe; einer C₁- bis C₃₀-Alkoxygruppe; einer C₁- bis C₃₀-Heteroalkylgruppe; einer C₁- bis C₃₀-Heteroalkoxygruppe; einer C₆- bis C₃₀-Arylalkylgruppe; einer C₆- bis C₃₀-Aryloxygruppe; einer C₆- bis C₃₀-Arylamingruppe; einer C₆- bis C₃₀-Pyrrolgruppe; einer C₆- bis C₃₀-Thiophengruppe; einer C₂- bis C₃₀-Heteroarylgruppe; einer C₂- bis C₃₀-Heteroarylalkylgruppe; einer C₂- bis C₃₀-Heteroaryloxygruppe; einer C₅- bis C₂₀-Cycloalkylgruppe; einer C₂- bis C₃₀-Heterocycloalkylgruppe; einer C₁-bis C₃₀-Alkylestergruppe; einer C₁- bis C₃₀-Heteroalkylestergruppe; einer C₆- bis C₃₀-Arylestergruppe und einer C₂- bis C₃₀-Heteroarylestergruppe.

3. Leitfähiges Polymer nach Anspruch 1, wobei das leitfähige Polymer ein Polymer ist, das durch Polymerisation einer Verbindung als ein Monomer erhalten wird, das durch die folgende chemische Formel 8 dargestellt wird: 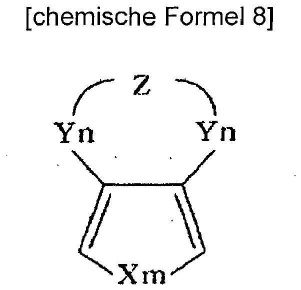 wobei in der chemischen Formel 8
X NH oder ein Heteroatom ist, das aus N, O, S und P ausgewählt ist, das mit einer C₁- bis C₂₀-Alkylgruppe oder einer C₆- bis C₂₀-Arylgruppe verbunden ist,
X NH oder ein Heteroatom ist, das aus N, O, S und P ausgewählt ist, das mit einer C₁- bis C₂₀-Alkylgruppe oder einer C₆- bis C₂₀-Arylgruppe verbunden ist,
m und n jeweils eine ganze Zahl im Bereich von 0 bis 9 sind, und
Z -(CH₂)ₓ-CRgRh-(CH₂)_{y} ist, wobei Rg und Rh gleich oder verschieden sind und unabhängig ausgewählt sind aus H, einem C₁- bis C₂₀-Alkylradikal, einem C₆- bis C₁₄-Arylradikal und -CH₂-ORi, wobei Ri aus der Gruppe bestehend aus H, einer C₁- bis C₆-Alkylsäure, einem C₁- bis C₆-Alkylester, einer C₁- bis C₆-Heteroalkylsäure und einer C₁- bis C₆-Alkylsulfonsäure ausgewählt wird.

4. Leitfähige Polymerzusammensetzung für eine organische photoelektrische Vorrichtung, mit einem leitfähigen Polymer nach einem der Ansprüche 1 bis 3 und einem Lösungsmittel.

5. Leitfähige Polymerzusammensetzung nach Anspruch 4, wobei das Lösungsmittel mindestens ein Lösungsmittel ist, das ausgewählt ist aus der Gruppe bestehend aus Wasser, Alkohol, Dimethylformamid (DMF), Dimethylsulfoxid, Toluol, Xylen und Chlorbenzen.

6. Leitfähige Polymerzusammensetzung nach Anspruch 4, wobei die leitfähige Polymerzusammensetzung ein physikalisches Vernetzungsmittel oder ein chemisches Vernetzungsmittel aufweist.

7. Leitfähige Polymerzusammensetzung nach Anspruch 6, wobei das physikalische Vernetzungsmittel mindestens eine aus der Gruppe Glycerin, Butanol, Polyvinylalkohol, Polyethylenglykol, Polyethylenimin und Polyvinylpyyrolidon ausgewählte Komponente ist.

8. Leitfähige Polymerzusammensetzung nach Anspruch 6, wobei das chemische Vernetzungsmittel mindestens eine aus der Gruppe Tetraethyloxysilan, Polyaziridin, einem Polymer auf Melaminbasis und einem Polymer auf Epoxidbasis ausgewählte Komponente ist.

9. Leitfähige Polymerzusammensetzung nach Anspruch 6, wobei das physikalische Vernetzungsmittel in einer Menge von 0,001 bis 5 Gewichtsanteilen basierend auf 100 Gewichtsanteilen der leitfähigen Polymerzusammensetzung nach Anspruch 6 enthalten sein kann.

10. Leitfähige Polymerzusammensetzung nach Anspruch 6, wobei das chemische Vernetzungsmittel in einer Menge von 0,001 bis 50 Gewichtsanteilen basierend auf 100 Gewichtsanteilen der leitfähigen Polymerzusammensetzung nach Anspruch 6 enthalten sein kann.

11. Leitfähige Polymerzusammensetzungsschicht für eine organische photoelektrische Vorrichtung, die unter Verwendung der leitfähigen Polymerzusammensetzung nach einem der Ansprüche 4 bis 10 hergestellt ist.

12. Organische photoelektrische Vorrichtung, die die leitfähige Polymerzusammensetzungsschicht nach Anspruch 11 aufweist.

## Revendications

1. Polymère conducteur dopé avec un copolymère polyacide représenté par la Formule Chimique 1 suivante : 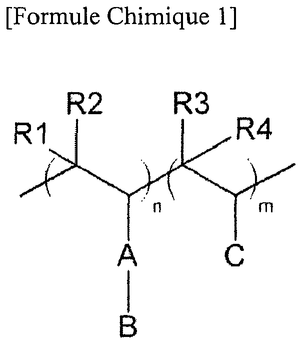 dans lequel, dans la Formule Chimique 1,
A est un groupe à base de carbone, et est choisi dans le groupe constitué par un groupe alkyle en C1 à C30 substitué ou non substitué ; un groupe hétéroalkyle en C1 à C30 substitué ou non substitué ; un groupe alcoxy en C1 à C30 substitué ou non substitué ; un groupe hétéroalcoxy en C1 à C30 substitué ou non substitué ; un groupe aryle en C6 à C30 substitué ou non substitué, un groupe arylalkyle en C6 à C30 substitué ou non substitué, un groupe aryloxy en C6 à C30 substitué ou non substitué, un groupe hétéroaryle en C2 à C30 substitué ou non substitué, un groupe hétéroarylalkyle en C2 à C30 substitué ou non substitué ; un groupe hétéroaryloxy en C2 à C30 substitué ou non substitué ; un groupe cycloalkyle en C5 à C20 substitué ou non substitué ; un groupe hétérocycloalkyle en C2 à C30 substitué ou non substitué; un groupe alkylester en C1 à C30 substitué ou non substitué; un groupe hétéroalkylester en C1 à C30 substitué ou non substitué ; un groupe arylester en C6 à C30 substitué ou non substitué ; et un groupe hétéroarylester en C2 à C30 substitué ou non substitué,
B est un groupe ionique ou un groupe comprenant un groupe ionique, dans lequel le groupe ionique comprend une paire de cation et anion, le cation est un ion métallique de Na⁺, K⁺, Li⁺, Mg²⁺, Zn²⁺, ou Al³⁺, H⁺, NH³⁺, ou un ion organique de CH3(-CH2-)ₙ (n est un nombre naturel de 1 à 50), et l'anion est PO3⁻, SO3⁻, COO⁻, I⁻, ou CH3COO⁻,
C est le cation d'un sel d'ion organique comprenant un anion et un cation,
R1 à R4 sont identiques ou différents, et sont indépendamment choisis dans le groupe constitué par un hydrogène, un alkyle en C1 à C10 substitué ou non substitué, un aryle en C6 à C20 substitué ou non substitué, et un hétéroaryle en C3 à C20 substitué ou non substitué,
0<m≤10.000.000, 0<n<10.000.000, et 0,0001≤m/n≤100,
dans lequel C est une des Formules Chimiques 2 à 5 suivantes : 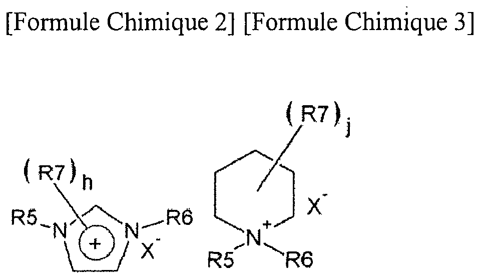 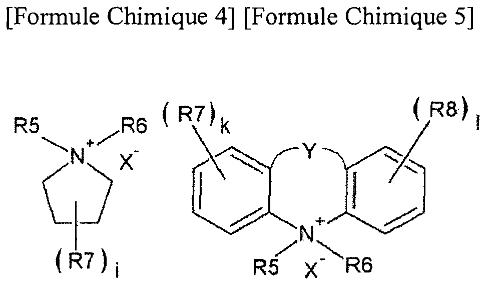 dans lequel, dans les Formules Chimiques 2 à 5,
un de R5 à R6 est choisi dans le groupe constitué par un groupe alkylène en C1 à C30 substitué ou non substitué, un groupe hétéroalkylène en C1 à C30 substitué ou non substitué, un groupe alcoxylène en C1 à C30 substitué ou non substitué, un groupe hétéroalkoxylène en C1 à C30 substitué ou non substitué, un groupe arylène en C6 à C30 substitué ou non substitué, un groupe arylalkylène en C6 à C30 substitué ou non substitué, un groupe hétéroarylène en C2 à C30 substitué ou non substitué, un groupe hétéroarylalkylène en C2 à C30 substitué ou non substitué, un groupe cycloalkylène en C5 à C20 substitué ou non substitué, et un groupe hétérocycloalkylène en C2 à C30 substitué ou non substitué, et est lié à une chaîne principale à son extrémité, et
le reste de R5 à R8 est identique ou différent est choisi indépendamment dans le groupe constitué par un hydrogène, un groupe alkyle en C1 à C30 substitué ou non substitué, un groupe hétéroalkyle en C1 à C30 substitué ou non substitué, un groupe alcoxy en C1 à C30 substitué ou non substitué, un groupe hétéroalcoxy en C1 à C30 substitué ou non substitué, un groupe aryle en C6 à C30 substitué ou non substitué, un groupe arylalkyle en C6 à C30 substitué ou non substitué, un groupe aryloxy en C6 à C30 substitué ou non substitué, un groupe hétéroaryle en C2 à C30 substitué ou non substitué, un groupe hétéroarylalkyle en C2 à C30 substitué ou non substitué, un groupe hétéroaryloxy en C2 à C30 substitué ou non substitué, un groupe cycloalkyle en C5 à C20 substitué ou non substitué, un groupe hétérocycloalkyle en C2 à C30 substitué ou non substitué, un groupe alkylester en C1 à C30 substitué ou non substitué, une groupe hétéroalkylester en C1 à C30 substitué ou non substitué, un groupe arylester en C6 à C30 substitué ou non substitué, et un groupe hétéroarylester en C2 à C30 substitué ou non substitué,
X de X- est choisi dans le groupe constitué par F, Cl, Br, I, BF₄, PF₆ et (CₙF₂ₙ₊₁SO₂)₂N (n est un nombre naturel de 1 à 50),
Y est choisi dans le groupe constitué par -CH2-, -CR'R"-, -NH-, -NR', -O-, -P-, -P=O-, - S-, et -SiR'R"-, dans lequel R' et R" sont identiques ou différents et sont choisis indépendamment dans le groupe constitué par un hydrogène, un alkyle en C1 à C10 substitué ou non substitué, un aryle en C6 à C20 substitué ou non substitué, et un hétéroaryle substitué ou non substitué en C3 à C20,
h est un nombre entier de 1 à 3,
i est un nombre entier de 1 à 8,
j est un nombre entier de 1 à 10,
k est un nombre entier de 1 à 4, et
1 est un nombre entier de 1 à 4.

2. Polymère conducteur selon la revendication 1, dans lequel le polymère conducteur est un polymère qui est obtenu par polymérisation d'un composé choisi dans le groupe constitué par un monomère de polyphénylène, polyphénylènevinylène, polyaniline, ou un dérivé de ceux-ci représenté par la Formule Chimique 6 suivante ; un monomère de pyrrole représenté par la Formule Chimique 7 suivante, un monomère de thiophène ou un dérivé de celui-ci :
[Formule Chimique 6] [Formule Chimique 7] 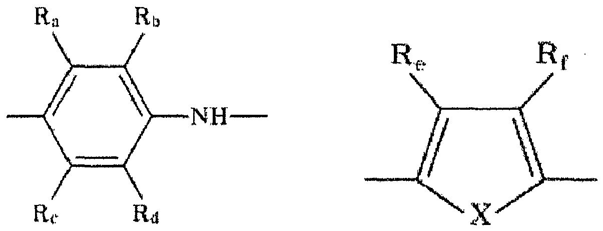
dans lequel, dans les Formules Chimiques 6 et 7,
X est NH ; ou un hétéroatome choisi parmi N, O, S, et P lié à un groupe alkyle en C1 à C20 ou un groupe aryle en C6 à C20,
Ra, Rb, Rc, et Rd sont identiques ou différents et sont choisis indépendamment dans le groupe constitué par un hydrogène ; un groupe alkyle en C1 à C30 ; un groupe hétéroalkyle en C1 à C30 ; un groupe alcoxy en C1 à C30 ; un groupe hétéroalcoxy en C1 à C30 ; un groupe aryle en C6 à C30 ; un groupe arylalkyle en C6 à C30 ; un groupe aryloxy en C6 à C30 ; un groupe arylamine en C6 à C30 ; un un groupe pyrrole en C6 à C30 ; un groupe thiophène en C6 à C30 ; un groupe hétéroaryle en C2 à C30 ; un groupe hétéroarylalkyle en C2 à C30 ; un groupe hétéroaryloxy en C2 à C30 ; un groupe cycloalkyle en C5 à C20 ; un groupe hétérocycloalkyle en C2 à C30 ; un groupe alkylester en C1 à C30 ; un groupe hétéroalkylester en C1 à C30 ; un groupe arylester en C6 à C30 ; et un groupe hétéroarylester en C2 à C30, et
Re et Rf sont identiques ou différents et choisis indépendamment dans le groupe constitué par NH ; ou un hétéroatome choisi parmi N, O, S, et P lié à un groupe alkyle en C1 à C20 ou un groupe arlye en C6 à C20 ; un groupe alkyle en C1 à C30 ; un groupe aryle en C6 à C30 ; un groupe alcoxy en C1 à C30 ; un groupe hétéroalkyle en C1 à C30 ; un groupe hétéroalcoxy en C1 à C30 ; un groupe arylalkyle en C6 à C30 ; un groupe aryloxy en C6 à C30 ; un groupe- arylamine en C6 à C30 ; un groupe pyrrole en C6 à C30 ; un groupe thiophène en C6 à C30 ; un groupe hétéroaryle en C2 à C30 ; un groupe hétéroarylalkyle en C2 à C30 ; un groupe hétéroaryloxy en C2 à C30 ; un groupe cycloalkyle en C5 à C20 ; un groupe hétérocycloalkyle en C2 à C30 ; un groupe alkylester en C1 à C30 ; un groupe hétéroalkylester en C1 à C30 ; un groupe arylester en C6 à C30 ; et un groupe hétéroarylester en C2 à C30.

3. Polymère conducteur selon la revendication 1, dans lequel le polymère conducteur est un polymère obtenu par polymérisation d'un composé représenté par la Formule Chimique 8 suivante en tant que monomère : 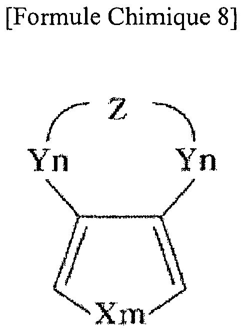 dans lequel, dans la Formule Chimique 8,
X est NH, ou un hétéroatome choisi parmi N, O, S, et P lié à un groupe alkyle en C1 à C20 ou un groupe aryle en C6 à C20,
Y est NH, ou un hétéroatome choisi parmi N, O, S, et P lié à un groupe alkyle en C1 à C20 ou un groupe aryle en C6 à C20,
m et n sont chacun indépendamment un nombre entier allant de 0 à 9, et
Z est -(CH₂)ₓ-CRgRh-(CH₂)_{y}, et Rg et Rh sont identiques ou différents et choisis indépendamment parmi H, un radical alkyle en C1 à C20, un radical aryle en C6 à C14, et un groupe -CH₂-ORi, dans lequel Ri est choisi dans le groupe constitué par H, un acide d'alkyle en C1 à C6, un alkylester en C1 à C6, un acide d'hétéroalkyle en C1 à C6, et un acide alkylsulfonique en C1 à C6.

4. Composition de polymère conducteur pour un dispositif photoélectrique organique comprenant le polymère conducteur selon l'une des revendications 1 à 3 et un solvant.

5. Composition de polymère conducteur pour dispositif photoélectrique organique selon la revendication 4, dans laquelle le solvant est au moins un solvant choisi dans le groupe constitué par de l'eau, un alcool, un diméthylformamide (DMF), un diméthylsulfoxyde, un toluène, un xylène et un chlorobenzène.

6. Composition de polymère conducteur pour dispositif photoélectrique organique selon la revendication 4, dans laquelle la composition de polymère conducteur comprend en outre un agent de réticulation physique ou un agent de réticulation chimique.

7. Composition de polymère conducteur pour dispositif photoélectrique organique selon la revendication 6, dans laquelle l'agent de réticulation physique est au moins un choisi dans le groupe constitué par un glycérol, un butanol, un alcool polyvinylique, un polyéthylèneglycol, une polyéthylèneimine, et une polyvinylpyrrolidone.

8. Composition de polymère conducteur pour dispositif photoélectrique organique selon la revendication 6, dans laquelle l'agent chimique de réticulation est au moins un choisi dans le groupe constitué par un tétraéthyloxysilane, une polyaziridine, un polymère à base de mélamine, et un polymère à base d'époxy.

9. Composition de polymère conducteur pour dispositif photoélectrique organique selon la revendication 6, dans laquelle l'agent de réticulation physique peut être incorporé dans une quantité de 0,001 à 5 parties en poids sur la base de 100 parties en poids de la composition de polymère conducteur selon la revendication 6.

10. Composition de polymère conducteur pour dispositif photoélectrique organique selon la revendication 6, dans laquelle l'agent de réticulation chimique peut être incorporé dans une quantité de 0,001 à 50 parties en poids sur la base de 100 parties en poids de la composition de polymère conducteur selon la revendication 6.

11. Couche de composition de polymère conducteur pour dispositif photoélectrique organique formée en utilisant la composition de polymère conducteur selon l'une des revendications 4 à 10.

12. Dispositif photoélectrique organique comprenant la couche de composition de polymère conducteur selon la revendication 11.
